# EUROPEAN PATENT APPLICATION

(11) **EP 4 326 027 A1**
(43) Date of publication of application: **21.02.2024**
(21) Application number: 23167349.2
(22) Date of filing: 11.04.2023
(51) Int. Cl.: H10B 43/27

(54) **SEMICONDUCTOR DEVICE AND AN ELECTRONIC SYSTEM INCLUDING THE SAME**

(30) Priority: 17.08.2022 KR 20220102697
(71) Applicant: Samsung Electronics Co., Ltd., Suwon-si, Gyeonggi-do 16677 (KR)
(72) Inventor: CHUN, Sanghun, 16677 Suwon-si (KR); CHOI, Hoyoung, 16677 Suwon-si (KR); PARK, Haeli, 16677 Suwon-si (KR); HAN, Jeehoon, 16677 Suwon-si (KR)
(74) Representative: Marks & Clerk LLP

(57) **Abstract**

A semiconductor device including: a first gate stack including first insulating patterns and first conductive patterns; a second gate stack on the first gate stack, the second gate stack including second insulating patterns and second conductive patterns; a memory channel structure penetrating the first and second gate stacks; a penetration contact penetrating the first and second gate stacks; and a barrier pattern on opposite sides of the penetration contact, the first insulating patterns include a first connection insulating pattern, which is an uppermost one of the first insulating patterns, the second insulating patterns include a second connection insulating pattern which is in contact with a top surface of the first connection insulating pattern, a bottom surface of the barrier pattern is in contact with the top surface of the first connection insulating pattern, and a top surface of the barrier pattern is in contact with the second connection insulating pattern.

## Description

### Technical Field

The present disclosure relates to a semiconductor device and an electronic system including the same, and in particular, to a semiconductor device including a barrier pattern and an electronic system including the same.

### Discussion of Related Art

Due to their small-sized, multifunctional, and/or low-cost characteristics, semiconductor devices are important elements in the electronics industry. The semiconductor devices are provided in a variety of types such as a semiconductor memory device for storing data, a semiconductor logic device for processing data, and a hybrid semiconductor device including memory and logic elements.

As demand for high speed and low power consumption electronic devices increases, semiconductor devices with high operating speeds and/or low operating voltages are being developed with high integration density. However, as the integration density of the semiconductor device increases, electrical characteristics and production yield of the semiconductor device may deteriorate. Accordingly, many studies are being conducted to improve the electrical characteristics and production yield of the semiconductor device.

### Summary

An embodiment of the inventive concept provides a semiconductor device with improved electrical and reliability characteristics and an electronic system including the same.

According to an embodiment of the inventive concept, a semiconductor device includes: a first gate stack including first insulating patterns and first conductive patterns, which are alternately stacked with each other; a second gate stack provided on the first gate stack, the second gate stack including second insulating patterns and second conductive patterns, which are alternately stacked with each other; a memory channel structure penetrating the first gate stack and the second gate stack; a penetration contact penetrating the first gate stack and the second gate stack; and a barrier pattern surrounding a part of the penetration contact, wherein the first insulating patterns include a first connection insulating pattern, which is the uppermost one of the first insulating patterns, the second insulating patterns include a second connection insulating pattern which is in contact with a top surface of the first connection insulating pattern, a bottom surface of the barrier pattern is in contact with the top surface of the first connection insulating pattern, and a top surface of the barrier pattern is in contact with the second connection insulating pattern.

According to an embodiment of the inventive concept, a semiconductor device includes: a first gate stack including a first insulating pattern and a first conductive pattern, which are alternately stacked with each other; a second gate stack provided on the first gate stack, the second gate stack including a second insulating pattern and a second conductive pattern, which are alternately stacked with each other; a memory channel structure penetrating the first gate stack and the second gate stack; a penetration contact penetrating the first gate stack and the second gate stack; and a barrier pattern surrounding a part of the penetration contact, wherein the first gate stack further includes a first contact insulating pattern provided on the first and second sides of the penetration contact, the second gate stack further includes a second contact insulating pattern provided on the first and second sides of the penetration contact, and the barrier pattern is disposed between the first contact insulating pattern and the second contact insulating pattern.

According to an embodiment of the inventive concept, an electronic system includes: a substrate; a semiconductor device on the substrate; and a controller, which is provided on the substrate and is electrically connected to the semiconductor device, wherein the semiconductor device includes: a first gate stack including first insulating patterns and first conductive patterns, which are alternately stacked with each other; a second gate stack provided on the first gate stack, the second gate stack including second insulating patterns and second conductive patterns, which are alternately stacked with each other; a memory channel structure penetrating the first gate stack and the second gate stack; a penetration contact penetrating the first gate stack and the second gate stack; and a barrier pattern surrounding a part of the penetration contact, wherein the first gate stack further includes first contact insulating patterns disposed on first and second sides of the penetration contact, the second gate stack further includes second contact insulating patterns disposed on the first and second sides of the penetration contact, the first insulating patterns include a first connection insulating pattern, which is disposed at a level higher than the first conductive patterns and the first contact insulating patterns, the second insulating patterns include a second connection insulating pattern, which is disposed at a level lower than the second conductive patterns and the second contact insulating patterns, the barrier pattern is disposed on a top surface of the first connection insulating pattern, and the second connection insulating pattern is in contact with a top surface of the barrier pattern.

According to an embodiment of the inventive concept, a method of fabricating a semiconductor device includes: forming a first stack including first insulating layers and first sacrificial layers, which are alternately stacked with each other; forming a first penetration contact hole to penetrate the first stack; forming a penetration contact sacrificial layer in the first penetration contact hole; forming a preliminary barrier pattern on the penetration contact sacrificial layer; forming a second stack, which includes second insulating layers and second sacrificial layers, on the first stack; forming a second penetration contact hole to penetrate the second stack and the preliminary barrier pattern; removing the penetration contact sacrificial layer through the second penetration contact hole; and forming a penetration contact in the first penetration contact hole and the second penetration contact hole.

### Brief Description of the Drawings

FIG. 1A is a diagram schematically illustrating an electronic system including a semiconductor device according to an embodiment of the inventive concept.
FIG. 1B is a perspective view schematically illustrating an electronic system including a semiconductor device according to an embodiment of the inventive concept.
FIGS. 1C and 1D are sectional views, each of which illustrates a semiconductor package according to an embodiment of the inventive concept.
FIG. 2A is a plan view illustrating a semiconductor device according to an embodiment of the inventive concept.
FIG. 2B is a sectional view taken along a line A-A' of FIG. 2A.
FIG. 2C is an enlarged view of a portion B of FIG. 2B.
FIG. 2D is a diagram illustrating a structure of a semiconductor device at a level C1 of FIG. 2C.
FIGS. 3, 4, 5, 6A, 6B, 7, 8A, 8B, 9, 10, 11A, 11B, 12A, 12B, 12C, 13A, 13B, 13C, 14A, 14B, and 14C are diagrams illustrating a method of fabricating a semiconductor device according to an embodiment of the inventive concept.
FIG. 15A is an enlarged sectional view illustrating a semiconductor device according to an embodiment of the inventive concept.
FIG. 15B is a diagram illustrating a structure of a semiconductor device at a level C2 of FIG. 15A.
FIGS. 16 and 17 are diagrams illustrating a method of fabricating a semiconductor device, according to an embodiment of the inventive concept.
FIG. 18 is a sectional view illustrating a semiconductor device according to an embodiment of the inventive concept.

### Detailed Description

Example embodiments of the inventive concept will now be described more fully with reference to the accompanying drawings.

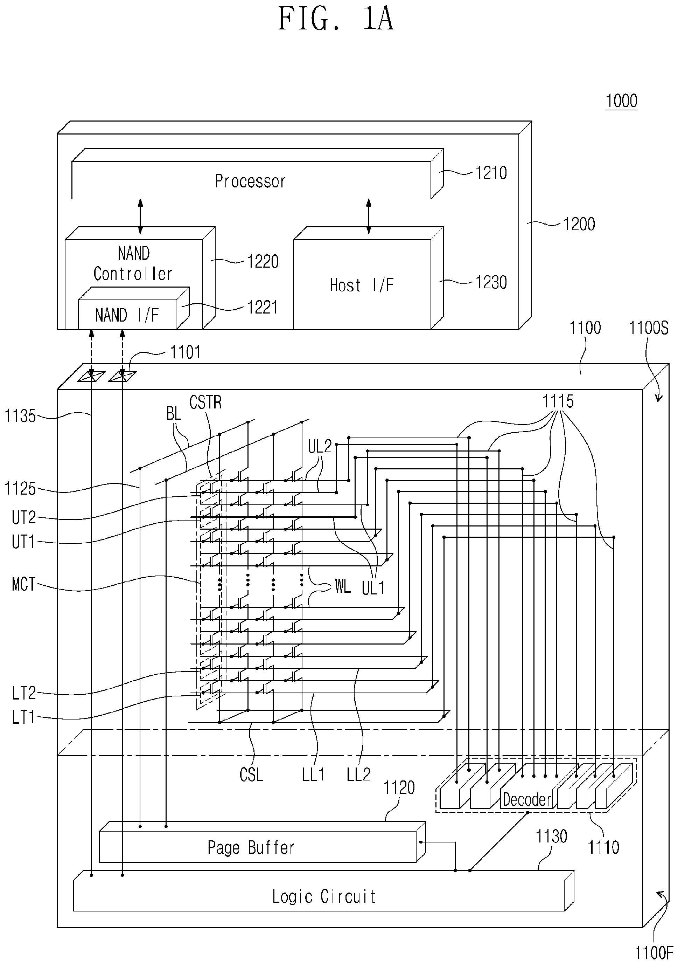

FIG. 1A is a diagram schematically illustrating an electronic system including a semiconductor device, according to an embodiment of the inventive concept.

Referring to FIG. 1A, an electronic system 1000 according to an embodiment of the inventive concept may include a semiconductor device 1100 and a controller 1200, which is electrically connected to the semiconductor device 1100. The electronic system 1000 may be a storage device including one or more semiconductor devices 1100 or an electronic device including the storage device. For example, the electronic system 1000 may be a solid state drive (SSD) device, a universal serial bus (USB), a computing system, a medical system, or a communication system, in which at least one semiconductor device 1100 is provided.

The semiconductor device 1100 may be a nonvolatile memory device and may be, for example, a NAND FLASH memory device. The semiconductor device 1100 may include a first structure 1100F and a second structure 1100S on the first structure 1100F. In an embodiment, the first structure 1100F may be disposed beside the second structure 1100S. The first structure 1100F may be a peripheral circuit structure, which includes a decoder circuit 1110, a page buffer 1120, and a logic circuit 1130. The second structure 1100S may be a memory cell structure, which includes a bit line BL, a common source line CSL, word lines WL, first and second gate upper lines UL1 and UL2, first and second gate lower lines LL1 and LL2, and memory cell strings CSTR between the bit line BL and the common source line CSL.

In the second structure 1100S, each of the memory cell strings CSTR may include lower transistors LT1 and LT2, which are adjacent to the common source line CSL, upper transistors UT1 and UT2, which are adjacent to the bit line BL, and a plurality of memory cell transistors MCT, which are disposed between the lower transistors LT1 and LT2 and the upper transistors UT1 and UT2. The number of the lower transistors LT1 and LT2 and the number of the upper transistors UT1 and UT2 may be variously changed, according to embodiments.

In an embodiment, the upper transistors UT1 and UT2 may include a string selection transistor, and the lower transistors LT1 and LT2 may include a ground selection transistor. The gate lower lines LL1 and LL2 may be respectively used as gate electrodes of the lower transistors LT1 and LT2. The word lines WL may be used as gate electrodes of the memory cell transistors MCT, respectively, and the gate upper lines UL1 and UL2 may be used as gate electrodes of the upper transistors UT1 and UT2, respectively.

The common source line CSL, the first and second gate lower lines LL1 and LL2, the word lines WL, and the first and second gate upper lines UL1 and UL2 may be electrically connected to the decoder circuit 1110 through first connection lines 1115, which are extended from the first structure 1100F into the second structure 1100S. The bit lines BL may be electrically connected to the page buffer 1120 through second connection lines 1125, which are extended from the first structure 1100F into the second structure 1100S.

In the first structure 1100F, the decoder circuit 1110 and the page buffer 1120 may be configured to perform a control operation on at least a selected one of the memory cell transistors MCT. The decoder circuit 1110 and the page buffer 1120 may be controlled by the logic circuit 1130. The semiconductor device 1100 may communicate with the controller 1200 through an input/output pad 1101, which is electrically connected to the logic circuit 1130. The input/output pad 1101 may be electrically connected to the logic circuit 1130 through an input/output connection line 1135, which is extended from the first structure 1100F to the second structure 1100S.

The controller 1200 may include a processor 1210, a NAND controller 1220, and a host interface 1230. In an embodiment, the electronic system 1000 may include a plurality of semiconductor devices 1100, and in this case, the controller 1200 may be configured to control the semiconductor devices 1100.

The processor 1210 may control overall operations of the electronic system 1000 including the controller 1200. The processor 1210 may be operated based on a specific firmware and may control the NAND controller 1220 to access the semiconductor device 1100. The NAND controller 1220 may include a NAND interface 1221 which is used for communication with the semiconductor device 1100. The NAND interface 1221 may be used to transmit and receive control commands to control the semiconductor device 1100, data to be written in or read from the memory cell transistors MCT of the semiconductor device 1100, and so forth. The host interface 1230 may be configured to allow for communication between the electronic system 1000 and an external host. When a control command is received from the external host through the host interface 1230, the processor 1210 may control the semiconductor device 1100 in response to the control command.

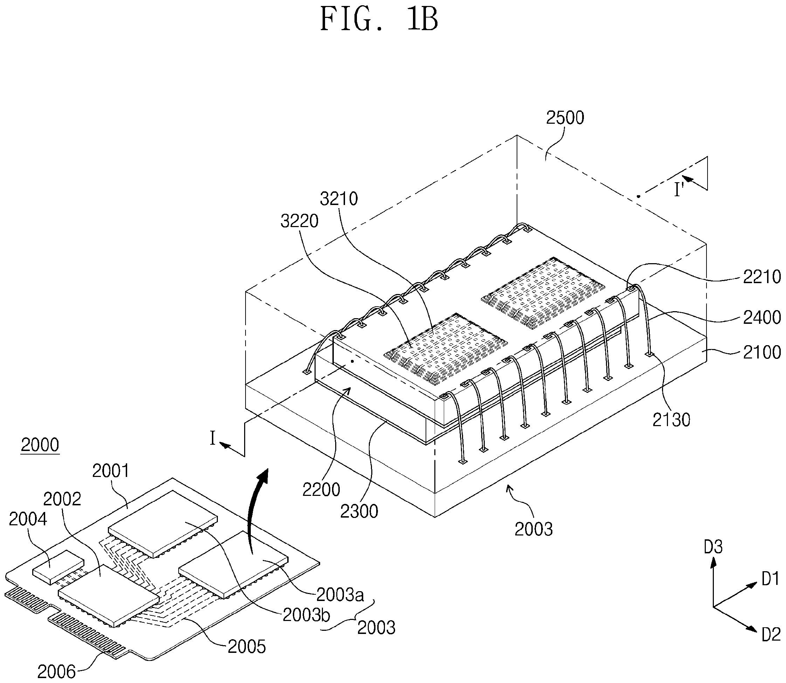

FIG. 1B is a perspective view schematically illustrating an electronic system including a semiconductor device, according to an embodiment of the inventive concept.

Referring to FIG. 1B, an electronic system 2000 according to an embodiment of the inventive concept may include a main substrate 2001 and a controller 2002, one or more semiconductor packages 2003, and a dynamic random access memory (DRAM) 2004, which are mounted on the main substrate 2001. The semiconductor package 2003 and the DRAM 2004 may be connected to the controller 2002 and to each other by interconnection patterns 2005, which are formed in the main substrate 2001.

The main substrate 2001 may include a connector 2006, which includes a plurality of pins for coupling to an external host. In the connector 2006, the number and arrangement of the pins may depend on a communication interface between the electronic system 2000 and the external host. In an embodiment, the electronic system 2000 may communicate with the external host, in accordance with one of interfaces, such as universal serial bus (USB), peripheral component interconnect express (PCI-Express), serial advanced technology attachment (SATA), universal flash storage (UFS) M-PHY, or the like. In an embodiment, the electronic system 2000 may be driven by an electric power, which is supplied from the external host through the connector 2006. The electronic system 2000 may further include a power management integrated circuit (PMIC) that is configured to distribute a power, which is supplied from the external host, to the controller 2002 and the semiconductor package 2003.

The controller 2002 may be configured to control a writing or reading operation on the semiconductor package 2003 and to improve an operation speed of the electronic system 2000.

The DRAM 2004 may be a buffer memory that is configured to relieve technical difficulties caused by a difference in speed between the semiconductor package 2003, which serves as a data storage device, and an external host. In an embodiment, the DRAM 2004 in the electronic system 2000 may serve as a cache memory and may be used as a storage space, which is used to temporarily store data during a control operation on the semiconductor package 2003. In the case where the electronic system 2000 includes the DRAM 2004, the controller 2002 may further include a DRAM controller for controlling the DRAM 2004, in addition to a NAND controller for controlling the semiconductor package 2003.

The semiconductor package 2003 may include first and second semiconductor packages 2003a and 2003b, which are spaced apart from each other. Each of the first and second semiconductor packages 2003a and 2003b may be a semiconductor package including a plurality of semiconductor chips 2200. Each of the first and second semiconductor packages 2003a and 2003b may include a package substrate 2100, the semiconductor chips 2200, which are provided on the package substrate 2100, adhesive layers 2300, which are respectively disposed in bottom surfaces of the semiconductor chips 2200, a connection structure 2400, which electrically connects the semiconductor chips 2200 to the package substrate 2100, and a molding layer 2500, which is provided on the package substrate 2100 to cover the semiconductor chips 2200 and the connection structure 2400.

The package substrate 2100 may be a printed circuit board, which includes package upper pads 2130. Each of the semiconductor chips 2200 may include an input/output pad 2210. The input/output pad 2210 may correspond to the input/output pad 1101 of FIG. 1A. Each of the semiconductor chips 2200 may include gate stacks 3210 and memory channel structures 3220. Each of the semiconductor chips 2200 may include a semiconductor device.

In an embodiment, the connection structure 2400 may be a bonding wire electrically connecting the input/output pad 2210 to the package upper pads 2130. Thus, in each of the first and second semiconductor packages 2003a and 2003b, the semiconductor chips 2200 may be electrically connected to each other in a bonding wire manner and may be electrically connected to the package upper pads 2130 of the package substrate 2100. Alternatively, in each of the first and second semiconductor packages 2003a and 2003b, the semiconductor chips 2200 may be electrically connected to each other by a connection structure including through-silicon vias (TSVs), not by the connection structure 2400 provided in the form of bonding wires.

In an embodiment, the controller 2002 and the semiconductor chips 2200 may be included in a single package. In an embodiment, the controller 2002 and the semiconductor chips 2200 may be mounted on an additional interposer substrate different from the main substrate 2001 and may be connected to each other through interconnection lines, which are provided in the interposer substrate.

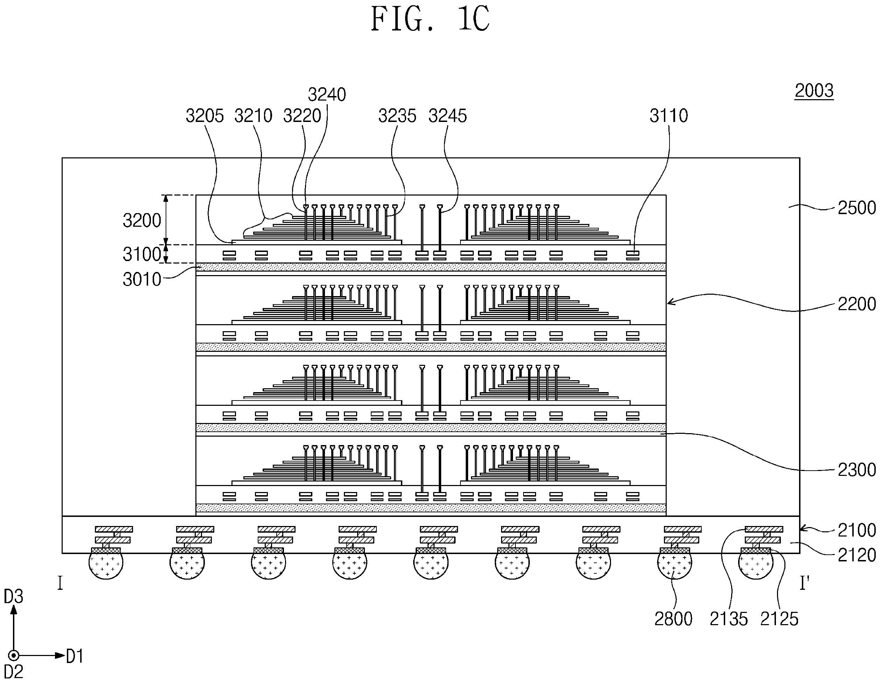

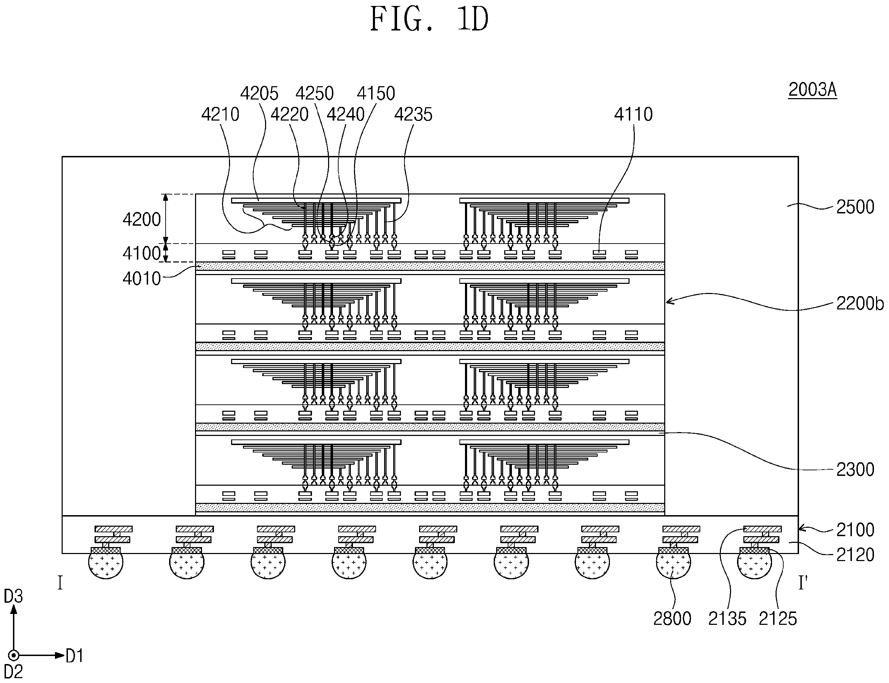

FIGS. 1C and 1D are sectional views schematically illustrating semiconductor packages according to an embodiment of the inventive concept. Each of FIGS. 1C and 1D schematically illustrates an example of the semiconductor package 2003 of FIG. 1B taken along a line I-I' of FIG. 1B.

Referring to FIG. 1C, in the semiconductor package 2003, the package substrate 2100 may be a printed circuit board. The package substrate 2100 may include a package substrate body portion 2120, package upper pads 2130 (e.g., of FIG. 1B) disposed on a top surface of the package substrate body portion 2120, lower pads 2125 disposed on or exposed through a bottom surface of the package substrate body portion 2120, and internal lines 2135 provided in the package substrate body portion 2120 to electrically connect the upper pads 2130 to the lower pads 2125. The upper pads 2130 may be electrically connected to the connection structures 2400 (e.g., of FIG. 1B). The lower pads 2125 may be connected to the interconnection patterns 2005 of the main substrate 2001 of the electronic system 2000, which is shown in FIG. 1B, through conductive connecting portions 2800.

Each of the semiconductor chips 2200 may include a semiconductor substrate 3010 and a first structure 3100 and a second structure 3200, which are sequentially stacked on the semiconductor substrate 3010. The first structure 3100 may include a peripheral circuit region provided with peripheral lines 3110. The second structure 3200 may include a common source line 3205, a gate stack 3210 on the common source line 3205, the memory channel structures 3220, which are provided to penetrate the gate stack 3210, bit lines 3240, which are electrically connected to the memory channel structures 3220, and gate contact plugs 3235, which are electrically connected to the word lines WL (e.g., see FIG. 1A) of the gate stack 3210.

Each of the semiconductor chips 2200 may be electrically connected to the peripheral lines 3110 of the first structure 3100 and may include a penetration line 3245, which is extended into the second structure 3200. The penetration line 3245 may be disposed outside the gate stack 3210. In an embodiment, the penetration line 3245 may be provided to penetrate the gate stack 3210. Each of the semiconductor chips 2200 may further include the input/output pad 2210 of FIG. 1B.

Referring to FIG. 1D, in a semiconductor package 2003A, each of semiconductor chips 2200b may include a semiconductor substrate 4010, a first structure 4100 on the semiconductor substrate 4010, and a second structure 4200, which is disposed on the first structure 4100 and is bonded to the first structure 4100 by a wafer bonding method.

The first structure 4100 may include a peripheral circuit region, in which a peripheral line 4110 and first junction structures 4150 are provided. The second structure 4200 may include a common source line 4205, a gate stack 4210 between the common source line 4205 and the first structure 4100, memory channel structures 4220, which are provided to penetrate the gate stack 4210, bit lines 4240 electrically connected to the memory channel structures 4220, gate contact plugs 4235, which are electrically connected to the word lines WL of FIG. 1A of the gate stack 4210, respectively, and second junction structures 4250. For example, the second junction structures 4250 may be electrically connected to the memory channel structures 4220, respectively, through the bit lines 4240, which are electrically connected to the memory channel structures 4220. The first junction structures 4150 of the first structure 4100 and the second junction structures 4250 of the second structure 4200 may be bonded to each other. In an embodiment, the bonding portion of the first and second junction structures 4150 and 4250 may be formed of copper (Cu). Each of the semiconductor chips 2200b may further include the input/output pad 2210 of FIG. 1B.

The semiconductor chips 2200 of FIG. 1C and the semiconductor chips 2200b of FIG. 1D may be electrically connected to each other by the connection structures 2400 of FIG. 1B, which are provided in the form of bonding wires. However, in an embodiment, semiconductor chips, which are provided in the same semiconductor package as the semiconductor chips 2200 of FIG. 1C or the semiconductor chips 2200b of FIG. 1D, may be electrically connected to each other through a connection structure including the through-silicon vias (TSVs).

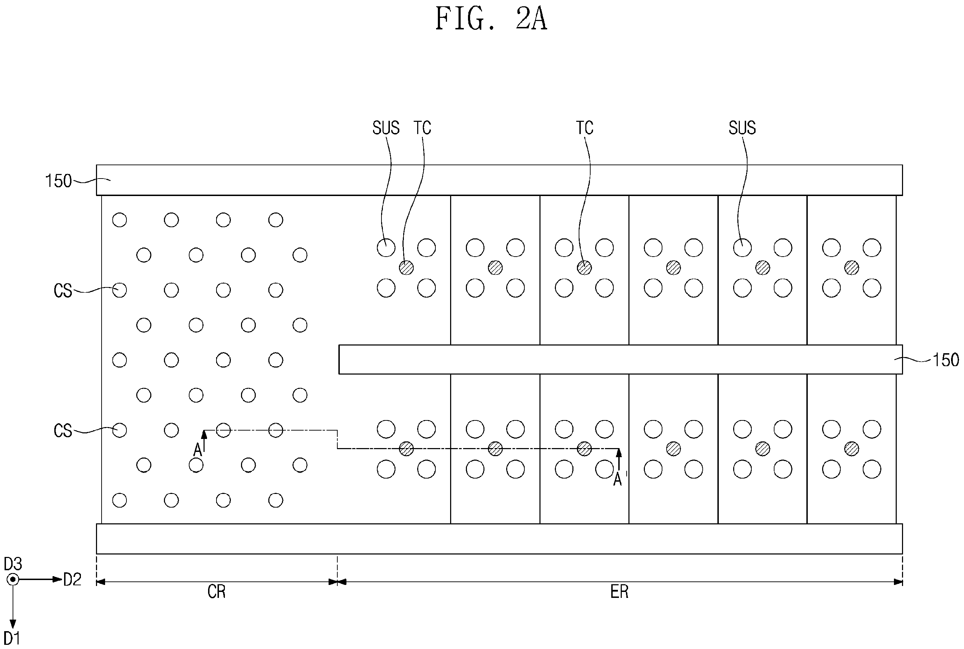

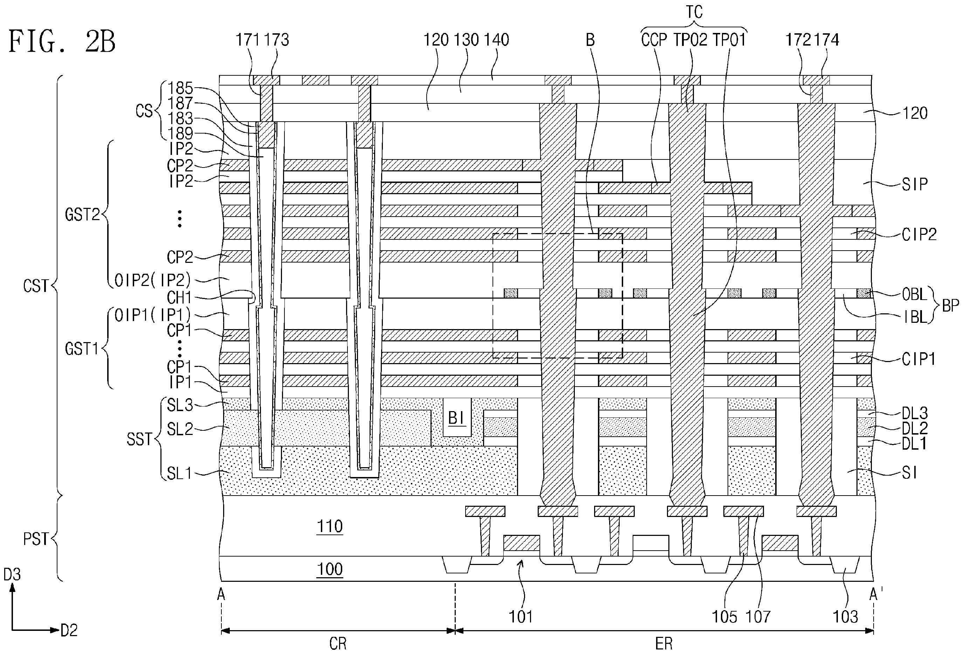

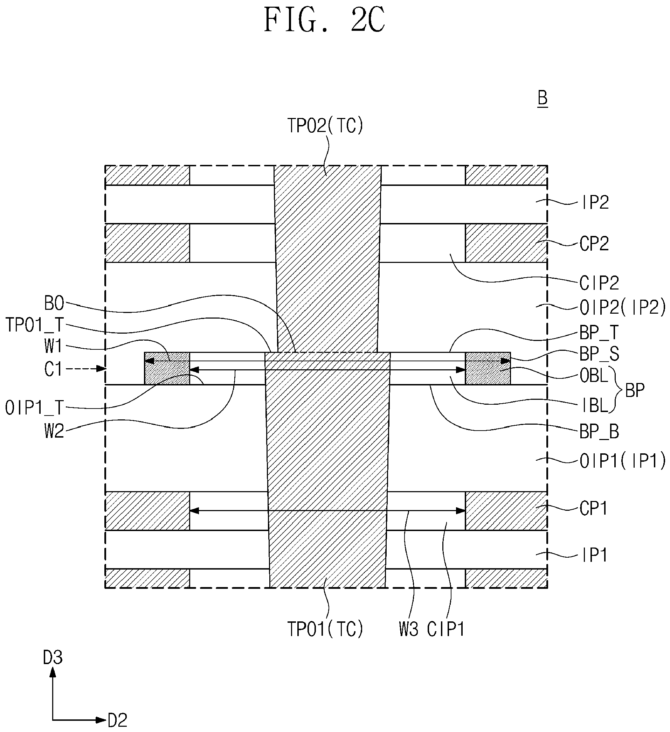

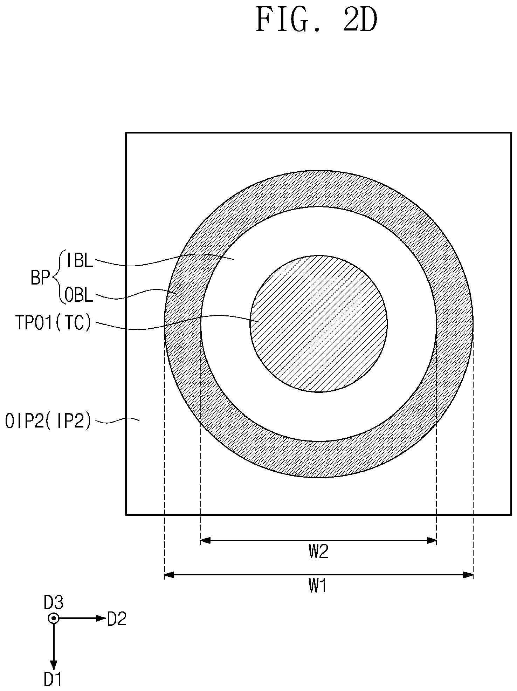

FIG. 2A is a plan view illustrating a semiconductor device according to an embodiment of the inventive concept. FIG. 2B is a sectional view taken along a line A-A' of FIG. 2A. FIG. 2C is an enlarged view of a portion B of FIG. 2B. FIG. 2D is a diagram illustrating a structure of a semiconductor device at a level C 1 of FIG. 2C.

Referring to FIGS. 2A and 2B, a semiconductor device according to an embodiment of the inventive concept may include a peripheral circuit structure PST and a memory cell structure CST on the peripheral circuit structure PST.

The peripheral circuit structure PST may include a substrate 100. The substrate 100 may be a plate-shaped structure that is extended parallel to a plane in a first direction D 1 and a second direction D2. The first and second directions D1 and D2 may not be parallel to each other. In an embodiment, the first and second directions D1 and D2 may be two different horizontal directions, which are orthogonal to each other. In an embodiment, the substrate 100 may be a semiconductor substrate. As an example, the substrate 100 may be formed of or include silicon, germanium, silicon-germanium, GaP, or GaAs. In an embodiment, the substrate 100 may be a silicon-on-insulator (SOI) substrate or a germanium-on-insulator (GOI) substrate.

The peripheral circuit structure PST may include a peripheral circuit insulating layer 110 on the substrate 100. The peripheral circuit insulating layer 110 may be formed of or include at least one of insulating materials. As an example, the peripheral circuit insulating layer 110 may be formed of or include an oxide material. In an embodiment, the peripheral circuit insulating layer 110 may be composed of a plurality of insulating layers.

The peripheral circuit structure PST may further include a peripheral transistor 101. The peripheral transistor 101 may be provided between the substrate 100 and the peripheral circuit insulating layer 110. In an embodiment, the peripheral transistor 101 may include source/drain regions, a gate electrode, and a gate insulating layer. Device isolation layers 103 may be provided in the substrate 100. The peripheral transistor 101 may be disposed between the device isolation layers 103. The device isolation layer 103 may be formed of or include at least one of insulating materials.

The peripheral circuit structure PST may further include peripheral contacts 105 and peripheral conductive lines 107. The peripheral contact 105 may be connected to the peripheral transistor 101 or the peripheral conductive line 107, and the peripheral conductive line 107 may be connected to the peripheral contact 105. The peripheral contact 105 and the peripheral conductive line 107 may be provided in the peripheral circuit insulating layer 110. The peripheral contact 105 and the peripheral conductive line 107 may be formed of or include at least one of conductive materials.

The memory cell structure CST may include a source structure SST, a first gate stack GST1, a second gate stack GST2, memory channel structures CS, supporting structures SUS, a first cover insulating layer 120, a second cover insulating layer 130, a third cover insulating layer 140, separation structures 150, first contacts 171, second contacts 172, bit lines 173, conductive lines 174, penetration contacts TC, and barrier patterns BP.

The source structure SST may include a cell region CR and an extension region ER. The cell region CR and the extension region ER may be two regions that are differentiated from each other in a plan view in the first and second directions D1 and D2.

The source structure SST may include a first source layer SL1 on the peripheral circuit structure PST, a second source layer SL2 on the first source layer SL1, a first dummy layer DL1, a second dummy layer DL2, and a third dummy layer DL3 on the first source layer SL1, and a third source layer SL3 on the second source layer SL2 and the first to third dummy layers DL1, DL2, and DL3.

The first to third source layers SL1, SL2, and SL3 may be formed of or include at least one of conductive materials. As an example, the first to third source layers SL1, SL2, and SL3 may be formed of or include poly silicon. The second source layer SL2 may be disposed in the cell region CR. The second source layer SL2 may be used as a common source line.

The first dummy layer DL1, the second dummy layer DL2, and the third dummy layer DL3 may be sequentially provided on the first source layer SL1 in the third direction D3. The first to third dummy layers DL1, DL2, and DL3 may be disposed in the extension region ER. The first to third dummy layers DL1, DL2, and DL3 may be disposed at the same level as the second source layer SL2. The first to third dummy layers DL1, DL2, and DL3 may be formed of or include at least one of insulating materials. In an embodiment, the first and third dummy layers DL1 and DL3 may be formed of or include substantially the same insulating material, and the second dummy layer DL2 may be formed of or include an insulating material that is different from the first and third dummy layers DL1 and DL3. As an example, the second dummy layer DL2 may be formed of or include nitride, and the first and third dummy layers DL1 and DL3 may be formed of or include oxide.

The third source layer SL3 may cover the second source layer SL2 and the first to third dummy layers DL1, DL2, and DL3. The third source layer SL3 may be in direct contact with the second source layer SL2, the first source layer SL1 and the third dummy layer DL3. The third source layer SL3 may be extended from the cell region CR to the extension region ER.

In an embodiment, the source structure SST may further include an insulating gapfill layer BI on the third source layer SL3. For example, the insulating gapfill layer BI may be located where the third source layer SL3 and the first source layer SL1 directly contact each other. The insulating gapfill layer BI may be provided between the cell region CR and the extension region ER. The insulating gapfill layer BI may be provided between the second source layer SL2 and the first to third dummy layers DL1, DL2, and DL3. The second source layer SL2 may be spaced apart from the first to third dummy layers DL1, DL2, and DL3 in the second direction D2, and in this case, the insulating gapfill layer BI and a portion of the third source layer SL3 enclosing the insulating gapfill layer BI may be interposed between the second source layer SL2 and the first to third dummy layers DL1, DL2, and DL3. The insulating gapfill layer BI may be formed of or include at least one of insulating materials.

The source structure SST may further include source insulating layers SI. The source insulating layers SI may be disposed in the extension region ER. The source insulating layer SI may enclose the penetration contact TC. The source insulating layer SI may be provided to penetrate the third source layer SL3, the first to third dummy layers DL1, DL2, and DL3, and the first source layer SL1. The source insulating layer SI may be surrounded by the third source layer SL3, the first to third dummy layers DL1, DL2, and DL3, and the first source layer SL1. The source insulating layer SI may be formed of or include at least one of insulating materials. As an example, the source insulating layer SI may be formed of or include an oxide material.

The first gate stack GST1 may be provided on the source structure SST. The first gate stack GST1 may include first insulating patterns IP1 and first conductive patterns CP1, which are alternately stacked on top of each other in the third direction D3. The third direction D3 may cross the first direction D1 and the second direction D2. As an example, the third direction D3 may be a vertical direction that is orthogonal to the first and second directions D1 and D2. The first insulating patterns IP1 may include a first connection insulating pattern OIP1, which is provided as the uppermost pattern of the first insulating patterns IP1.

The first insulating patterns IP1 may be formed of or include at least one of insulating materials. As an example, the first insulating patterns IP1 may be formed of or include an oxide material. The first conductive patterns CP1 may be formed of or include at least one of conductive materials. As an example, the first conductive patterns CP1 may be formed of or include tungsten.

The first gate stack GST1 may further include first contact insulating patterns CIP1. The first contact insulating patterns CIP1 may be provided in the extension region ER. The first contact insulating pattern CIP1 may be disposed at the same level as the first conductive pattern CP1. The first connection insulating pattern OIP1 may be disposed at a level that is higher than the first contact insulating patterns CIP1 and the first conductive patterns CP1. The first conductive pattern CP1 may be provided to enclose the first contact insulating pattern CIP1. The first contact insulating pattern CIP1 may be provided to enclose the penetration contact TC. The first contact insulating pattern CIP1 may be disposed between the first conductive pattern CP1 and the penetration contact TC. The first contact insulating pattern CIP1 may be formed of or include at least one of insulating materials. As an example, the first contact insulating pattern CIP1 may be formed of or include an oxide material.

The second gate stack GST2 may be provided on the first gate stack GST1. The second gate stack GST2 may include second insulating patterns IP2 and second conductive patterns CP2, which are alternately stacked on top of each other in the third direction D3. The second insulating patterns IP2 may include a second connection insulating pattern OIP2, which is provided as the lowermost pattern of the second insulating patterns IP2.

The second insulating patterns IP2 may be formed of or include at least one of insulating materials. As an example, the second insulating patterns IP2 may be formed of or include an oxide material. The second conductive patterns CP2 may be formed of or include at least one of conductive materials. As an example, the second conductive patterns CP2 may be formed of or include tungsten.

The second gate stack GST2 may further include second contact insulating patterns CIP2. The second contact insulating patterns CIP2 may be provided in the extension region ER. The second contact insulating pattern CIP2 may be disposed at the same level as the second conductive pattern CP2. The second connection insulating pattern OIP2 may be disposed at a level that is lower than the second contact insulating patterns CIP2 and the second conductive patterns CP2. The second conductive pattern CP2 may be provided to enclose the second contact insulating pattern CIP2. The second contact insulating pattern CIP2 may be provided to enclose the penetration contact TC. The second contact insulating pattern CIP2 may be disposed between the second conductive pattern CP2 and the penetration contact TC. The second contact insulating pattern CIP2 may be formed of or include at least one of insulating materials. As an example, the second contact insulating pattern CIP2 may be formed of or include an oxide material.

The second gate stack GST2 may include a stepwise structure, which is provided on the extension region ER of the source structure SST. The stepwise structure of the second gate stack GST2 may be formed by the second insulating patterns IP2 and the second conductive patterns CP2. The second gate stack GST2 may further include a staircase insulating pattern SIP, which is provided to cover the stepwise structure. The staircase insulating pattern SIP may be formed of or include at least one of insulating materials.

The number of the gate stacks GST1 and GST2 may not be limited to that in the illustrated example. In an embodiment, the number of the gate stacks GST1 and GST2 may be greater than three.

The memory channel structures CS may be extended in the third direction D3 to penetrate the first insulating patterns IP1 and the first conductive patterns CP1 of the first gate stack GST1, the second insulating patterns IP2 and the second conductive patterns CP2 of the second gate stack GST2, the third source layer SL3, and the second source layer SL2. The lowermost portion of the memory channel structure CS may be placed in the first source layer SL1.

Each of the memory channel structures CS may include an insulating capping layer 189, a channel layer 187 enclosing the insulating capping layer 189, and a memory layer 183 enclosing the channel layer 187.

The insulating capping layer 189 may be formed of or include at least one of insulating materials. As an example, the insulating capping layer 189 may be formed of or include an oxide material. The channel layer 187 may be formed of or include at least one of conductive materials. As an example, the channel layer 187 may be formed of or include polysilicon. The channel layer 187 may be electrically connected to the second source layer SL2. The second source layer SL2 may pass through the memory layer 183 and may be connected to the channel layer 187. For example, the second source layer SL2 may be in direct contact with the channel layer 187.

The memory layer 183 may be configured to store data. In an embodiment, the memory layer 183 may include a tunnel insulating layer enclosing the channel layer 187, a data storing layer enclosing the tunnel insulating layer, and a blocking layer enclosing the data storing layer.

Each of the memory channel structures CS may further include a bit line pad 185, which is provided on the channel layer 187. The bit line pad 185 may be formed of or include at least one of conductive materials. As an example, the bit line pad 185 may be formed of or include at least one of poly silicon or metallic materials.

The supporting structures SUS may be provided to penetrate the second gate stack GST2 and the first gate stack GST1. The supporting structure SUS may have a structure similar to the memory channel structure CS. However, in an embodiment, the supporting structure SUS may be formed of only an insulating material, unlike the memory channel structure CS.

The first cover insulating layer 120 may be provided on the second gate stack GST2. For example, the first cover insulating layer 120 may be in contact with an uppermost layer of the second insulating patterns IP2. The second cover insulating layer 130 may be provided on the first cover insulating layer 120. The third cover insulating layer 140 may be provided on the second cover insulating layer 130. The first to third cover insulating layers 120, 130, and 140 may be formed of or include at least one of insulating materials.

The penetration contacts TC may be extended in the third direction D3 to penetrate the first cover insulating layer 120, the second gate stack GST2, the barrier pattern BP, the first gate stack GST1, and the source structure SST. The penetration contact TC may include a first penetration portion TPO1, which is provided to penetrate the first gate stack GST1 and the barrier pattern BP, and a second penetration portion TPO2, which is disposed on the first penetration portion TPO1. The first penetration portion TPO1 may be connected to the peripheral conductive line 107 of the peripheral circuit structure PST. The penetration contact TC may include a contact connecting portion CCP, which is connected to the first or second conductive pattern CP1 or CP2. The penetration contact TC may be formed of or include at least one of conductive materials.

Each of the penetration contacts TC may be provided to penetrate a corresponding one of the barrier patterns BP. The barrier patterns BP may be provided to enclose the penetration contacts TC, respectively. The barrier patterns BP may be spaced apart from each other. The barrier patterns BP may be disposed at the same level as each other.

The separation structures 150 may be provided to penetrate the first and second gate stacks GST1 and GST2. The separation structures 150 may be extended in the second direction D2. The separation structure 150 may be formed of or include at least one of insulating materials. In an embodiment, the separation structure 150 may further include a conductive material.

The first contact 171 may be connected to the memory channel structure CS. The first contact 171 may be provided to penetrate the first and second cover insulating layers 120 and 130. The second contact 172 may be connected to the penetration contact TC. The second contact 172 may be provided to penetrate the second cover insulating layer 130. The bit line 173 may be connected to the first contact 171. The bit line 173 may be disposed in the third cover insulating layer 140. The bit line 173 may be extended in the first direction D1. The conductive line 174 may be connected to the second contact 172. The conductive line 174 may be disposed in the third cover insulating layer 140. The first contact 171, the second contact 172, the bit line 173, and the conductive line 174 may be formed of or include at least one of conductive materials.

Referring to FIGS. 2C and 2D, the barrier pattern BP may be provided on the first gate stack GST1. A bottom surface BP_B of the barrier pattern BP may be in contact with a top surface OIP1_T of the first connection insulating pattern OIP1 of the first gate stack GST1. The second gate stack GST2 may cover the barrier pattern BP. The second connection insulating pattern OIP2 of the second gate stack GST2 may be in contact with a top surface BP_T and a side surface BP_S of the barrier pattern BP. The second connection insulating pattern OIP2 of the second gate stack GST2 may enclose the barrier pattern BP. The barrier pattern BP may be disposed in the second connection insulating pattern OIP2 of the second gate stack GST2.

The barrier pattern BP may include an inner barrier layer IBL, which is provided to enclose the penetration contact TC, and an outer barrier layer OBL, which is provided to enclose the inner barrier layer IBL. The inner barrier layer IBL may contact a sidewall of the penetration contact TC and the outer barrier layer OBL may be disposed between the inner barrier layer IBL and a portion of the second connection insulating pattern OIP2. When viewed in the plan view of FIG. 2D, the barrier pattern BP may be circular. When viewed in the plan view of FIG. 2D, the inner barrier layer IBL and the outer barrier layer OBL may have a ring shape.

A top surface TPO1_T of the first penetration portion TPO1 may be coplanar with the top surface BP_T of the barrier pattern BP. The top surface TPO1_T of the first penetration portion TPO1, a boundary BO between the first and second penetration portions TPO1 and TPO2, and the top surface BP_T of the barrier pattern BP may be located at the same level. A width of the first penetration portion TPO1 may decrease as a distance from the top surface BP_T of the barrier pattern BP increases in a direction toward the first contact insulating pattern CIP 1. A width of the second penetration portion TPO2 may increase as a distance from the top surface BP_T of the barrier pattern BP increases in a direction toward the second contact insulating pattern CIP2. In other words, each of the first and second penetration portions TPO1 and TPO2 may have a tapered shape.

The top surface BP_T of the barrier pattern BP may include a top surface of the outer barrier layer OBL and a top surface of the inner barrier layer IBL. The bottom surface BP_B of the barrier pattern BP may include a bottom surface of the outer barrier layer OBL and a bottom surface of the inner barrier layer IBL. The side surface BP_S of the barrier pattern BP may be an outer side surface of the outer barrier layer OBL.

The first contact insulating patterns CIP1 may be disposed at a level lower than the barrier pattern BP. The second contact insulating patterns CIP2 may be disposed at a level higher than the barrier pattern BP. The barrier pattern BP may be disposed between the first contact insulating patterns CIP1 and the second contact insulating patterns CIP2. The first connection insulating pattern OIP1 may be provided between the barrier pattern BP and the first contact insulating patterns CIP1, and the second connection insulating pattern OIP2 may be provided between the barrier pattern BP and the second contact insulating patterns CIP2. The barrier pattern BP, the first contact insulating patterns CIP1, and the second contact insulating patterns CIP2 may be overlapped with each other in the third direction D3.

The largest width of the barrier pattern BP may be larger than the largest width of the first contact insulating pattern CIP1. In other words, the barrier pattern BP is wider than the first contact insulating pattern CIP1. As an example, the largest width W1 of the barrier pattern BP in the second direction D2 may be larger than the largest width W3 of the first contact insulating pattern CIP1 in the second direction D2. The largest width of the barrier pattern BP may be the largest width of the outer barrier layer OBL. The largest width of the inner barrier layer IBL may be larger than the largest width of the first contact insulating pattern CIP1. As an example, the largest width W2 of the inner barrier layer IBL in the second direction D2 may be larger than the largest width W3 of the first contact insulating pattern CIP1 in the second direction D2. In an embodiment, the largest width of the barrier pattern BP may be larger than the largest width of the second contact insulating pattern CIP2.

In an embodiment, the largest width W1 of the barrier pattern BP in the second direction D2 may range from 200 nm to 600 nm. A distance between the outer side surface of the outer barrier layer OBL and the outer side surface of the inner barrier layer IBL in the second direction D2 may range 50 nm to 200 nm.

The inner barrier layer IBL may be overlapped with the first contact insulating pattern CIP1, the second contact insulating pattern CIP2, the first conductive pattern CP1, and the second conductive pattern CP2 in the third direction D3. The outer barrier layer OBL may be overlapped with the first conductive pattern CP1 and the second conductive pattern CP2 in the third direction D3. The outer barrier layer OBL may not be overlapped with the first and second contact insulating patterns CIP1 and CIP2 in the third direction D3.

A thickness of the barrier pattern BP in the third direction D3 may be smaller than a thickness of the second connection insulating pattern OIP2 in the third direction D3. A thickness of the barrier pattern BP in the third direction D3 may also be smaller than a thickness of the first connection insulating pattern OIP1 in the third direction D3. In an embodiment, the thickness of the barrier pattern BP in the third direction D3 may range from 10 nm to 50 nm.

The barrier pattern BP may be formed of or include a material different from the first and second contact insulating patterns CIP1 and CIP2. The inner barrier layer IBL of the barrier pattern BP may be formed of or include the same material as the first and second contact insulating patterns CIP1 and CIP2, and the outer barrier layer OBL of the barrier pattern BP may be formed of or include a material different from the first and second contact insulating patterns CIP1 and CIP2. For example, the inner barrier layer IBL of the barrier pattern BP may be formed of or include an oxide material, and the outer barrier layer OBL of the barrier pattern BP may be formed of or include a nitride material. In an embodiment, the oxide material of the inner barrier layer IBL may be silicon oxide, and the nitride material of the outer barrier layer OBL may be silicon nitride.

In an embodiment, the barrier pattern BP may be formed of or include a material that is different from the first and second insulating patterns IP1 and IP2. In this case, the inner barrier layer IBL of the barrier pattern BP may be formed of or include the same material as the first and second insulating patterns IP1 and IP2, and the outer barrier layer OBL of the barrier pattern BP may be formed of or include a material different from the first and second insulating patterns IP1 and IP2.

In the semiconductor device according to an embodiment of the inventive concept, due to the barrier pattern BP, the second connection insulating pattern OIP2 may be protected in the process of forming the penetration contact TC. Thus, it is possible not only to reduce a thickness of the second connection insulating pattern OIP2 but also to secure a sufficient distance between the penetration contact TC and the second conductive pattern CP2.

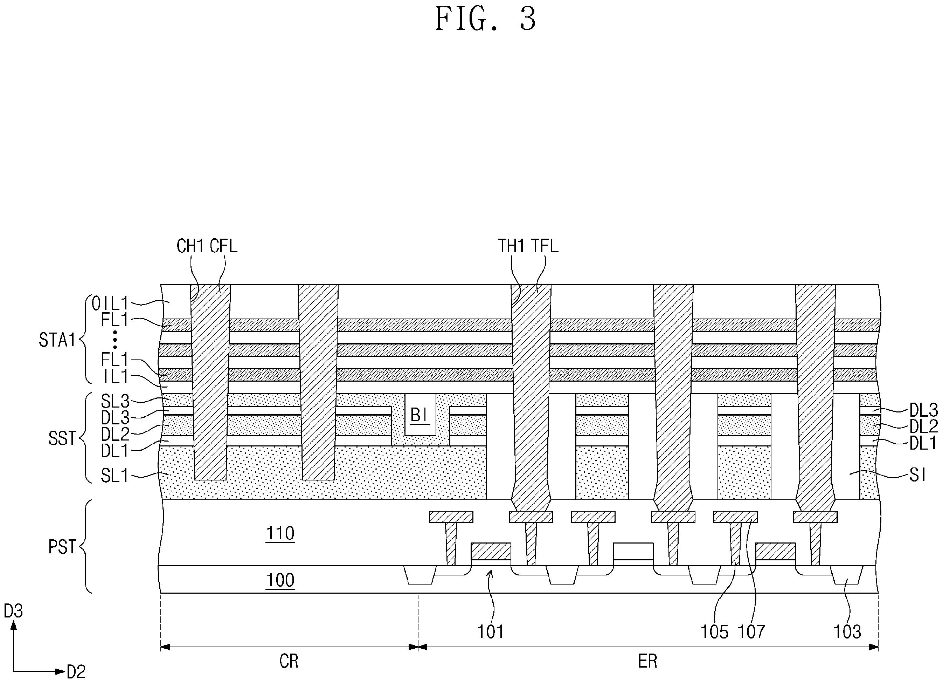

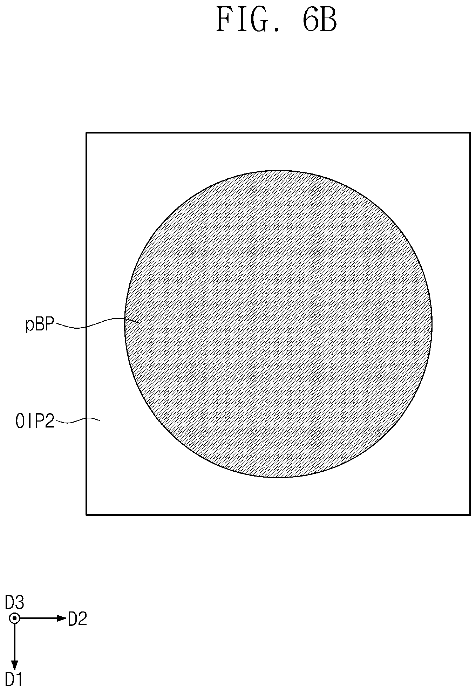

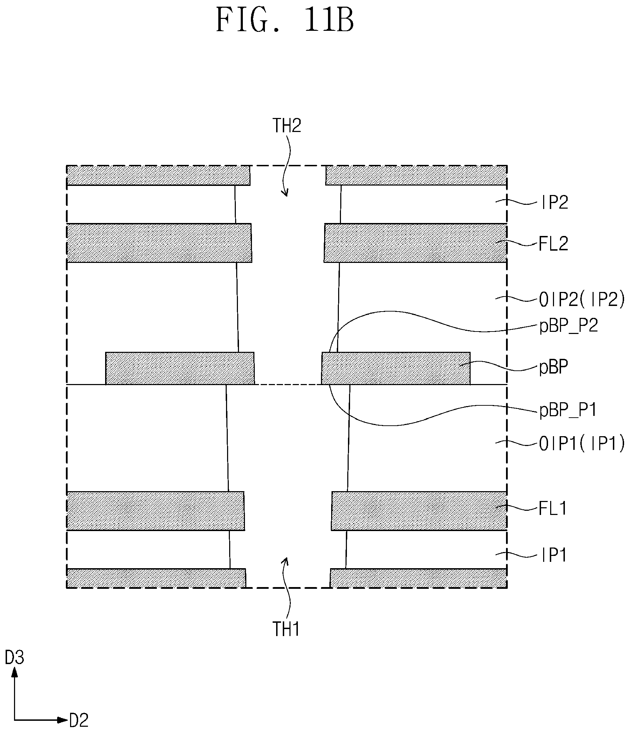

FIGS. 3, 4, 5, 6A, 6B, 7, 8A, 8B, 9, 10, 11A, 11B, 12A, 12B, 12C, 13A, 13B, 13C, 14A, 14B, and 14C are diagrams illustrating a method of fabricating a semiconductor device according to an embodiment of the inventive concept. FIGS. 3, 4, 5, 6A, 7A, 8A, 9, 10, 11A, 12A, 13A, and 14A illustrate a structure corresponding to FIG. 2B. FIGS. 6B, 8B, 12C, 13C, and 14C illustrate a structure corresponding to FIG. 2D. FIGS. 11B, 12B, 13B, and 14B illustrate a structure corresponding to FIG. 2C.

Referring to FIG. 3, the peripheral circuit structure PST may be formed. The formation of the peripheral circuit structure PST may include forming the peripheral transistors 101, the device isolation layers 103, the peripheral contacts 105, the peripheral conductive lines 107, and the peripheral circuit insulating layer 110 on the substrate 100.

The source structure SST may be formed on the peripheral circuit structure PST. The formation of the source structure SST may include forming the first source layer SL1 on the peripheral circuit structure PST, forming the first to third dummy layers DL1, DL2, and DL3 on the first source layer SL1 and on the cell and extension regions CR and ER, forming the third source layer SL3, forming the insulating gapfill layer BI on the third source layer SL3, and forming the source insulating layers SI on the extension region ER to penetrate the third source layer SL3, the first to third dummy layers DL1, DL2, and DL3, and the first source layer SL1.

A first stack STA1 may be formed on the source structure SST. The first stack STA1 may include first insulating layers IL1 and first sacrificial layers FL1, which are alternately stacked on top of each other in the third direction D3. The first insulating layer IL1 and the first sacrificial layer FL1 may be formed of or include materials having an etch selectivity with respect to each other. As an example, the first insulating layer IL1 may be formed of or include an oxide material, and the first sacrificial layer FL1 may be formed of or include a nitride material.

The first stack STA1 may further include a first connection insulating layer OIL1, which is provided as the uppermost layer of the first stack STA1. The first connection insulating layer OIL1 may be formed of or include the same material as the first insulating layer IL1.

First channel holes CH1 and first penetration contact holes TH1 may be formed to extend in the third direction D3 and to penetrate the first stack STA1. The first channel holes CH1 may be formed on the cell region CR of the source structure SST. The first penetration contact holes TH1 may be formed on the extension region ER of the source structure SST. The lowermost portion of the first channel hole CH1 may be positioned in the first source layer SL1. The lowermost portion of the first penetration contact hole TH1 may be positioned in the peripheral circuit insulating layer 110 of the peripheral circuit structure PST. The first penetration contact hole TH1 may be connected to the peripheral conductive line 107.

In an embodiment, a sacrificial pattern, which is enclosed by the source insulating layer SI, may be formed before the formation of the first stack STA1, and in this case, the formation of the first penetration contact hole TH1 may include exposing the sacrificial pattern and removing the sacrificial pattern.

A channel sacrificial layer CFL may be formed in the first channel hole CH1. A penetration contact sacrificial layer TFL may be formed in the first penetration contact hole TH1. The channel sacrificial layer CFL and the penetration contact sacrificial layer TFL may be formed of or include a material having an etch selectivity with respect to the first insulating layer IL1 and the first sacrificial layer FL1. For example, the channel sacrificial layer CFL and the penetration contact sacrificial layer TFL may be formed of or include at least one of tungsten or titanium.

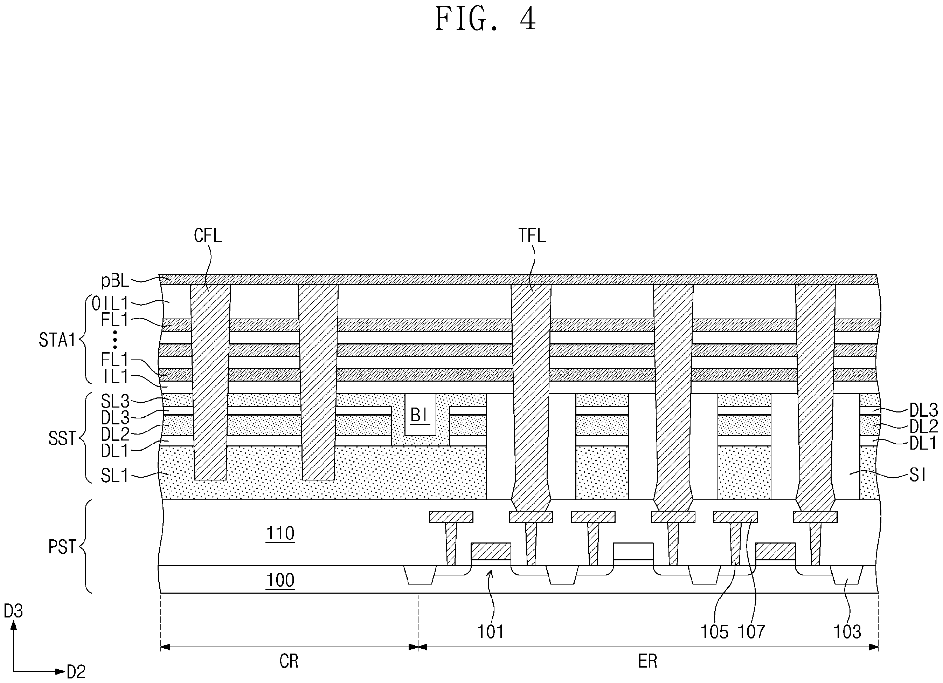

Referring to FIG. 4, a preliminary barrier layer pBL may be formed on the first stack STA1, the channel sacrificial layer CFL, and the penetration contact sacrificial layer TFL. The preliminary barrier layer pBL may be in contact with a top surface of the first connection insulating layer OIL1 of the first stack STA1, a top surface of the channel sacrificial layer CFL, and a top surface of the penetration contact sacrificial layer TFL.

The preliminary barrier layer pBL may be formed of or include a material that is different from the first insulating layer IL1 and the first connection insulating layer OII,1. The preliminary barrier layer pBL may be formed of or include the same material as the first sacrificial layer FL1. For example, the preliminary barrier layer pBL may be formed of or include a nitride material. In an embodiment, the nitride material of the preliminary barrier layer pBL may be silicon nitride.

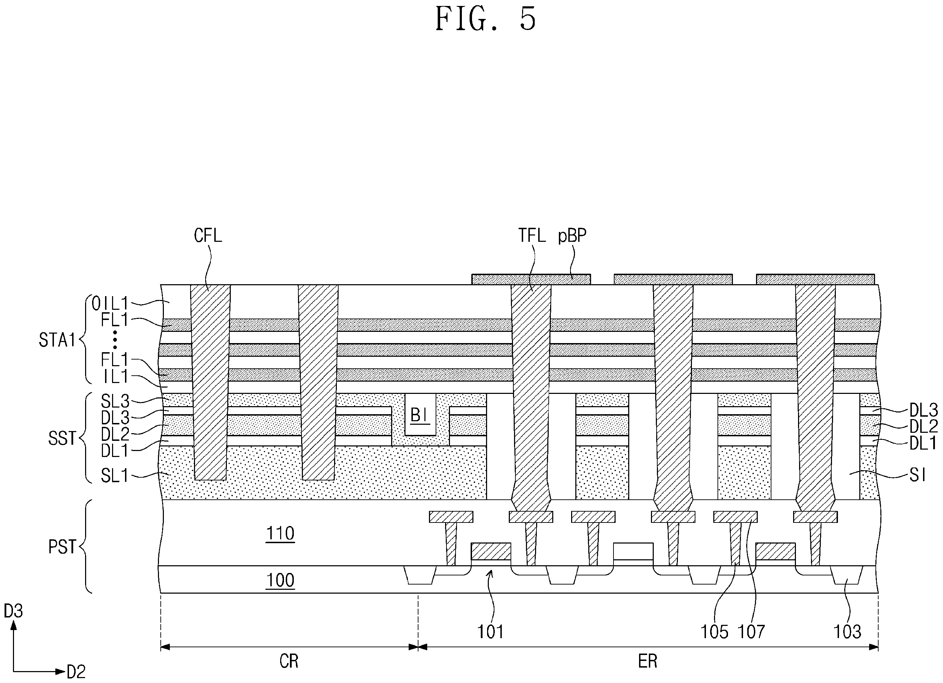

Referring to FIG. 5, preliminary barrier patterns pBP may be formed by patterning the preliminary barrier layer pBL. Each of the preliminary barrier patterns pBP may be provided on the penetration contact sacrificial layers TFL, respectively. The preliminary barrier pattern pBP may be in contact with the top surface of the penetration contact sacrificial layer TFL and the top surface of the first connection insulating layer OIL1 of the first stack STA1. The preliminary barrier patterns pBP may be spaced apart from each other. The preliminary barrier pattern pBP may be circular, when viewed in a plan view.

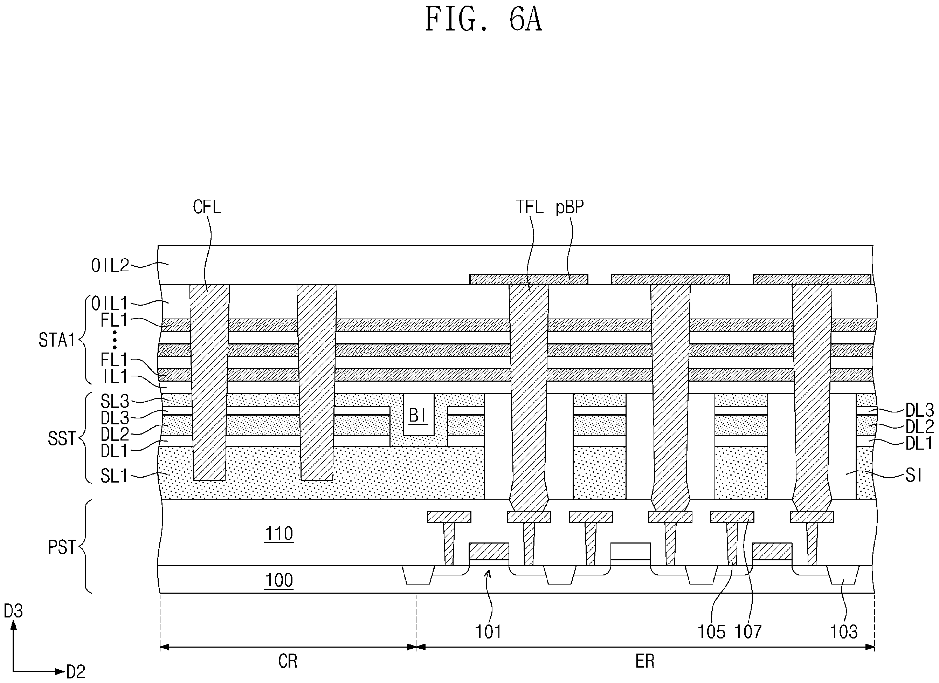

Referring to FIGS. 6A and 6B, a second connection insulating layer OIL2 may be formed to cover the preliminary barrier patterns pBP. The second connection insulating layer OIL2 may be provided to enclose the preliminary barrier pattern pBP. The second connection insulating layer OIL2 may be in contact with top and side surfaces of the preliminary barrier pattern pBP. The preliminary barrier pattern pBP may be provided in the second connection insulating layer OIL2. The second connection insulating layer OIL2 may be in contact with the top surface of the first connection insulating layer OIL1. The second connection insulating layer OIL2 may be formed of or include the same insulating material as the first insulating layer IL1 and the first connection insulating layer OIL1.

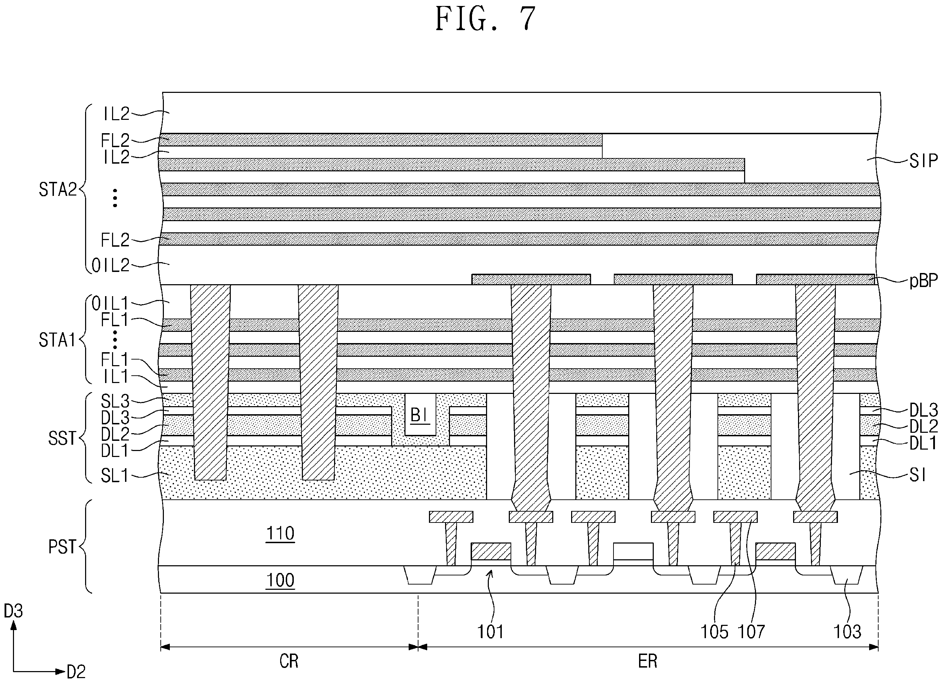

Referring to FIG. 7, second sacrificial layers FL2 and second insulating layers IL2, which are alternately stacked on top of each other in the third direction D3, may be formed on the second connection insulating layer OIL2. A structure including the second connection insulating layer OIL2, the second sacrificial layers FL2, and the second insulating layers IL2 may constitute a second stack STA2. The second insulating layer IL2 may be formed of or include the same insulating material as the first insulating layer IL1 and the first and second connection insulating layers OIL1 and OIL2. The second sacrificial layer FL2 may be formed of or include the same insulating material as the first sacrificial layer FL1 and the preliminary barrier pattern pBP.

The second stack STA2 may further include the staircase insulating pattern SIP. A stepwise structure, which is formed by the second sacrificial layers FL2 and the second insulating layers IL2, may be formed, and then, the staircase insulating pattern SIP may be formed on the stepwise structure.

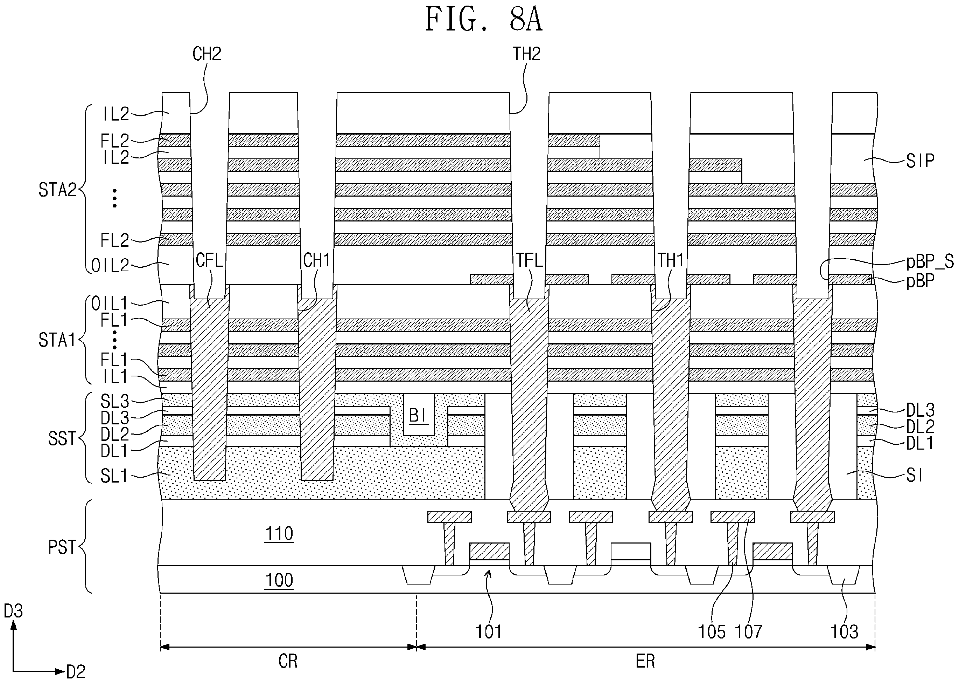

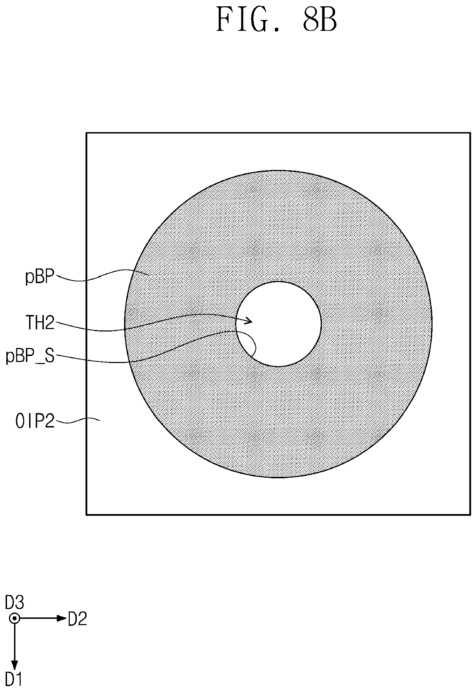

Referring to FIGS. 8A and 8B, second channel holes CH2 and second penetration contact holes TH2 may be formed to extend in the third direction D3 and to penetrate the second stack STA2. The second channel hole CH2 may be connected to the first channel hole CH1. The second penetration contact hole TH2 may be connected to the first penetration contact hole TH1. The second channel holes CH2 may be formed on the cell region CR of the source structure SST. The second penetration contact holes TH2 may be formed on the extension region ER of the source structure SST.

The second channel hole CH2 may be formed to expose the channel sacrificial layer CFL. The second penetration contact hole TH2 may be formed to expose the penetration contact sacrificial layer TFL. The second penetration contact hole TH2 may penetrate the preliminary barrier pattern pBP. In addition, the second penetration contact hole TH2 may penetrate a part of the penetration contact sacrificial layer TFL beneath the preliminary barrier pattern pBP. The formation of the second penetration contact hole TH2 may include etching a center portion of the preliminary barrier pattern pBP. A side surface pBP_S of the preliminary barrier pattern pBP may be exposed through the second penetration contact hole TH2.

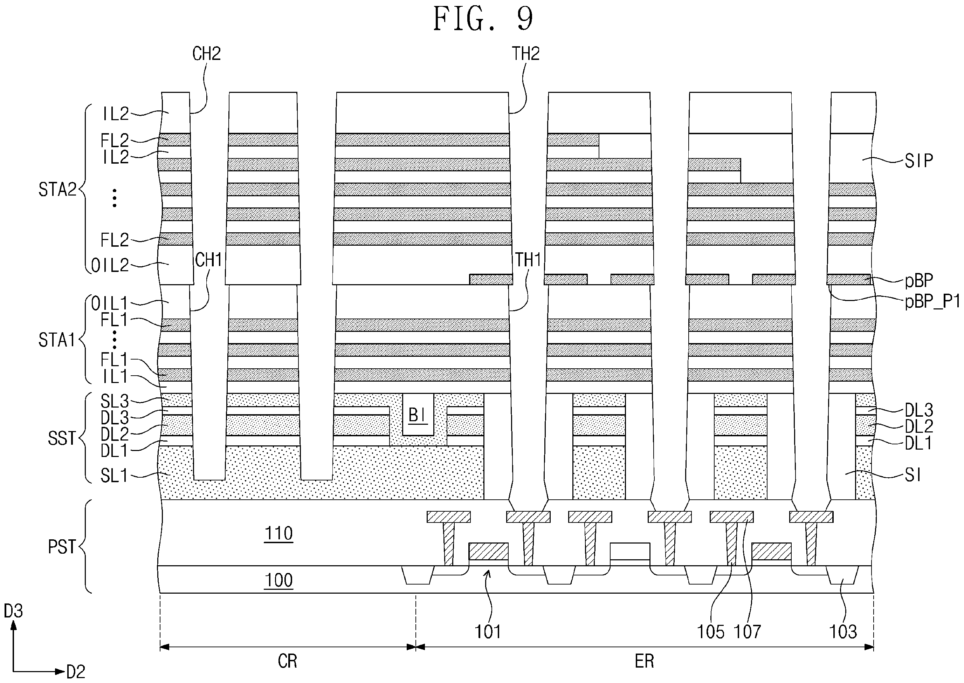

Referring to FIG. 9, the channel sacrificial layer CFL exposed through the second channel hole CH2 may be removed. The penetration contact sacrificial layer TFL exposed through the second penetration contact hole TH2 may be removed. As a result of the removal of the channel sacrificial layer CFL, the first channel hole CH1 may be opened. As a result of the removal of the penetration contact sacrificial layer TFL, the first penetration contact hole TH1 may be opened. Since the penetration contact sacrificial layer TFL is removed, a portion pBP_P1 exposed through the first penetration contact hole TH1 may be defined on the bottom surface of the preliminary barrier pattern pBP. In other words, the portion pBP_P1 of the preliminary barrier pattern pBP may overlap the first penetration contact hole TH1.

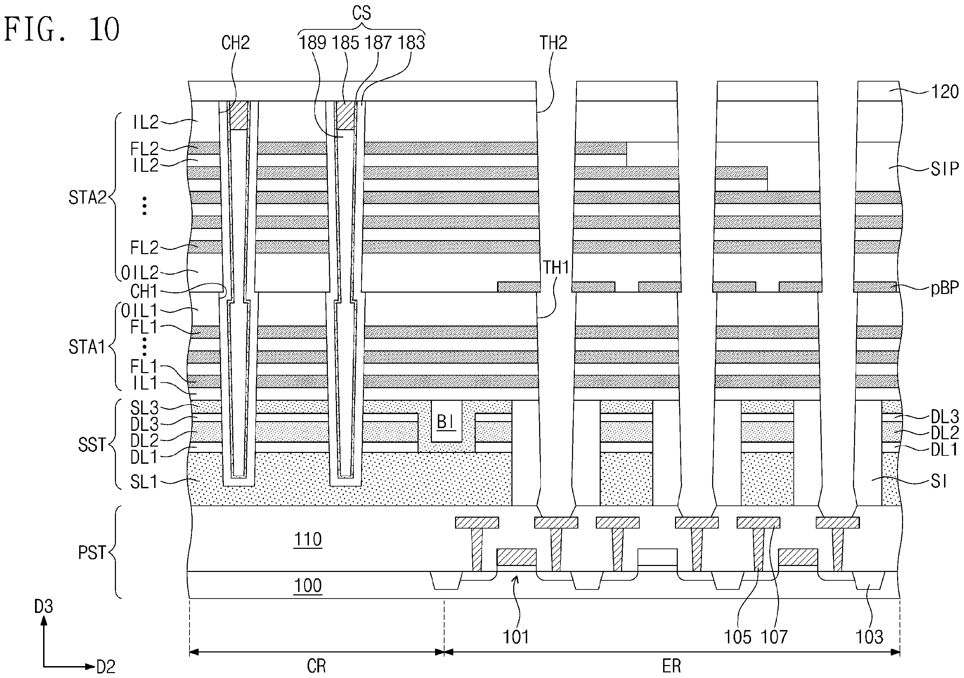

Referring to FIG. 10, the memory channel structure CS may be formed in the first and second channel holes CH1 and CH2. The memory channel structure CS may include the insulating capping layer 189, the channel layer 187, the memory layer 183, and the bit line pad 185.

The first cover insulating layer 120 may be formed on the memory channel structure CS and the second stack STA2. The first cover insulating layer 120 may be patterned to open (or expose) the second penetration contact hole TH2. In an embodiment, the first cover insulating layer 120 may be formed after forming a sacrificial material in the first and second penetration contact holes TH1 and TH2, and the sacrificial material may be removed from the first and second penetration contact holes TH1 and TH2, after the patterning of the first cover insulating layer 120.

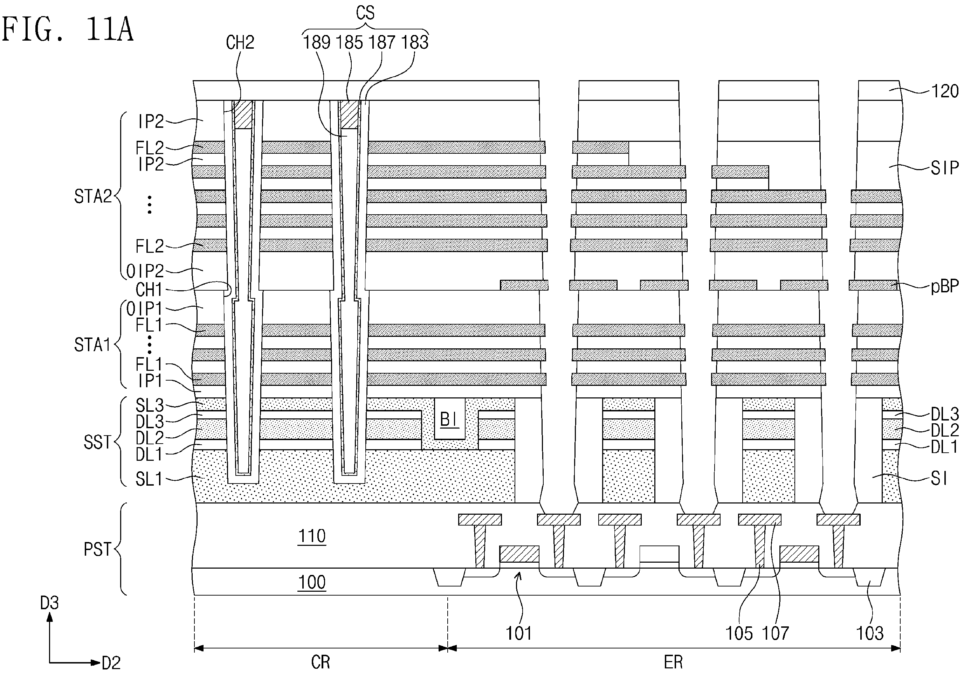

Referring to FIGS. 11A and 11B, a first etching process may be performed. The first etching process may include selectively etching the first and second insulating layers IL1 and IL2, the first and second connection insulating layers OIL1 and OIL2, and the source insulating layer SI through the first and second penetration contact holes TH1 and TH2. As a result of the first etching process, the first and second penetration contact holes TH1 and TH2 may be enlarged.

The etched first insulating layers IL1 and the etched first connection insulating layer OIL1 may be referred to as the first insulating patterns IP1. The etched first connection insulating layer OIL1 may be referred to as the first connection insulating pattern OIP1. The etched second insulating layers IL2 and the etched second connection insulating layer OIL2 may be referred to as the second insulating patterns IP2. The etched second connection insulating layer OIL2 may be referred to as the second connection insulating pattern OIP2.

As a result of the first etching process, the portion pBP_P1 of the preliminary barrier pattern pBP, whose bottom surface is exposed through the first penetration contact hole TH1, may be enlarged. As a result of the first etching process, a top surface of a portion pBP_P2 of the preliminary barrier pattern pBP may be exposed through the second penetration contact hole TH2.

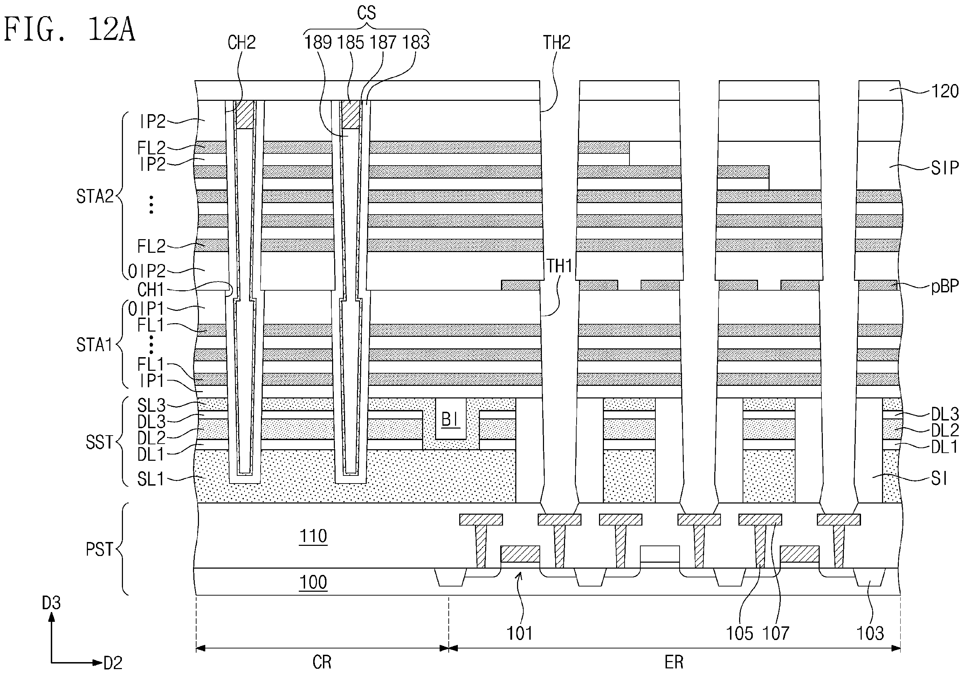

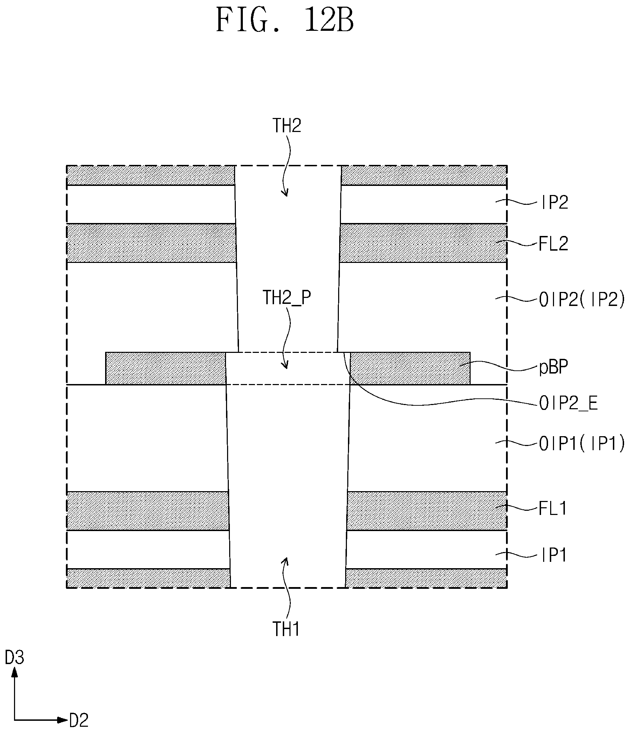

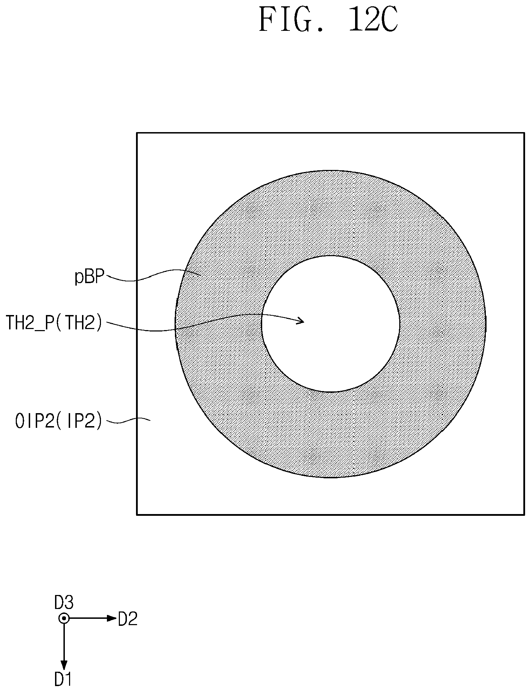

Referring to FIGS. 12A, 12B, and 12C, a second etching process may be performed. The second etching process may include selectively etching the first and second sacrificial layers FL1 and FL2 and the preliminary barrier pattern pBP through the first and second penetration contact holes TH1 and TH2. As a result of the second etching process, the first and second penetration contact holes TH1 and TH2 may be enlarged.

As a result of the second etching process, the portion pBP_P1 of the preliminary barrier pattern pBP, whose bottom surface is exposed through the first penetration contact hole TH1, may be removed. As a result of the second etching process, the portion pBP_P2 of the preliminary barrier pattern pBP, whose top surface is exposed through the second penetration contact hole TH2, may be removed. In an embodiment, the second etching process may be performed to remove a portion of the preliminary barrier pattern pBP, which is located between the two portions pBP_P1 and pBP_P2 of the preliminary barrier pattern pBP. In this case, the preliminary barrier pattern pBP does not protrude into the first penetration contact hole TH1 and/of the second penetration contact hole TH2.

As a result of the second etching process, a portion TH2_P of the second penetration contact hole TH2, which is enclosed by the preliminary barrier pattern pBP, may be enlarged. The portion TH2_P of the second penetration contact hole TH2, which is enclosed by the preliminary barrier pattern pBP, may be disposed at the same level as the preliminary barrier pattern pBP. As a result of the enlargement of the portion TH2_P of the second penetration contact hole TH2, the second connection insulating pattern OIP2 may have an exposed surface OIP2_E that is exposed to the outside. The exposed surface OIP2_E of the second connection insulating pattern OIP2 may be located at substantially the same level as the top surface of the preliminary barrier pattern pBP.

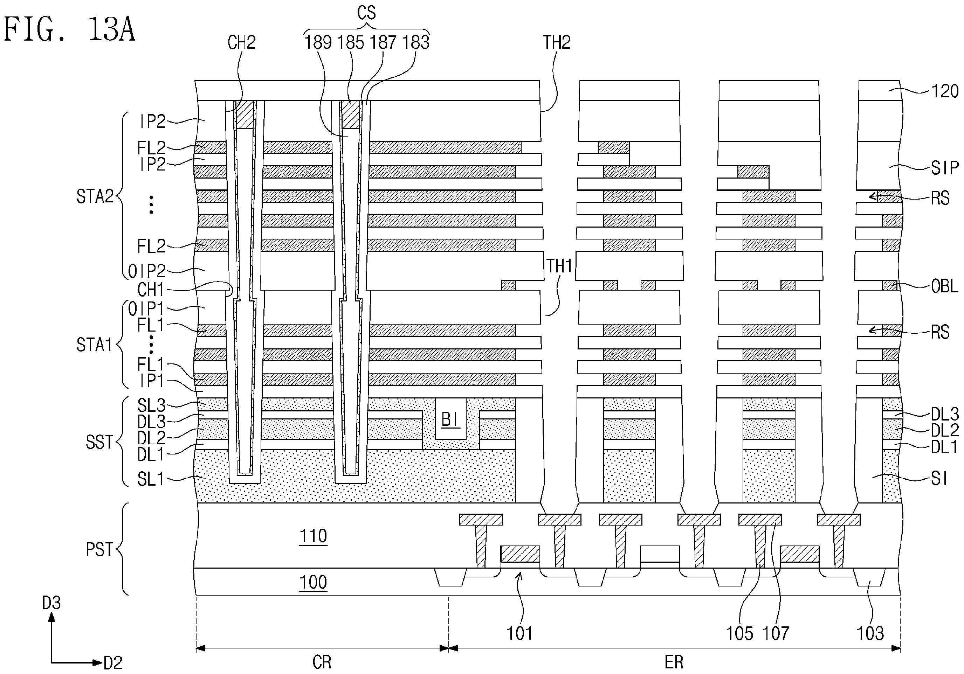

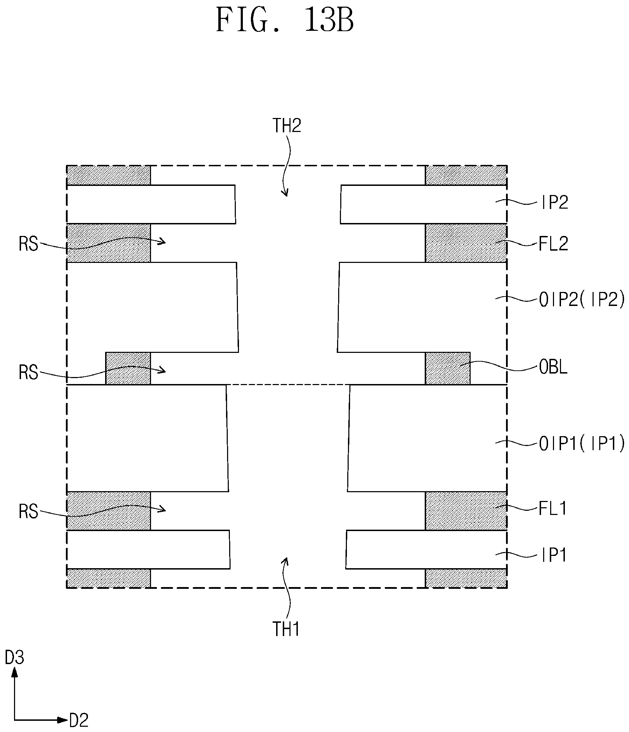

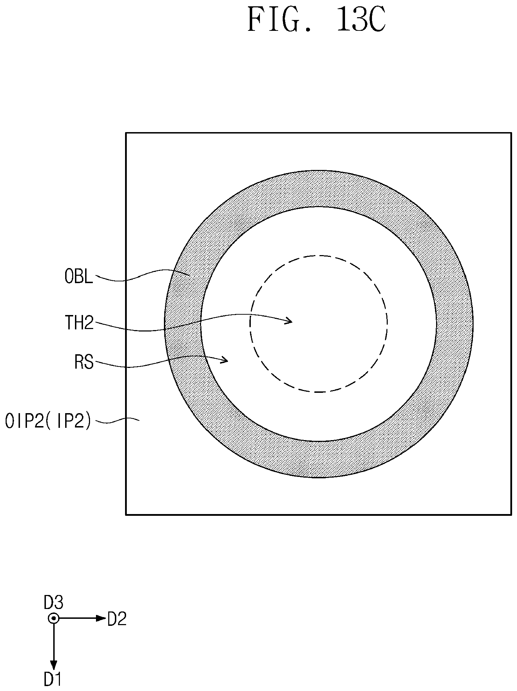

Referring to FIGS. 13A, 13B, and 13C, a third etching process may be performed. The third etching process may include selectively etching the first and second sacrificial layers FL1 and FL2 and the preliminary barrier pattern pBP through the first and second penetration contact holes TH1 and TH2. The preliminary barrier pattern pBP, which is etched by the third etching process, may be referred to as the outer barrier layer OBL.

Recesses RS may be formed by the third etching process. The recesses RS may be empty spaces, which are formed by etching the first and second sacrificial layers FL1 and FL2 and the preliminary barrier pattern pBP through the third etching process. The recess RS may be connected to the first penetration contact hole TH1 or the second penetration contact hole TH2. The recess RS may be defined by a side surface of the first sacrificial layer FL1, a side surface of the second sacrificial layer FL2, or a side surface of the outer barrier layer OBL. The recesses RS may be defined by surfaces of the first and second insulating patterns IP1 and IP2. When viewed in the plan view of FIG. 13C, the recess RS may have a ring shape.

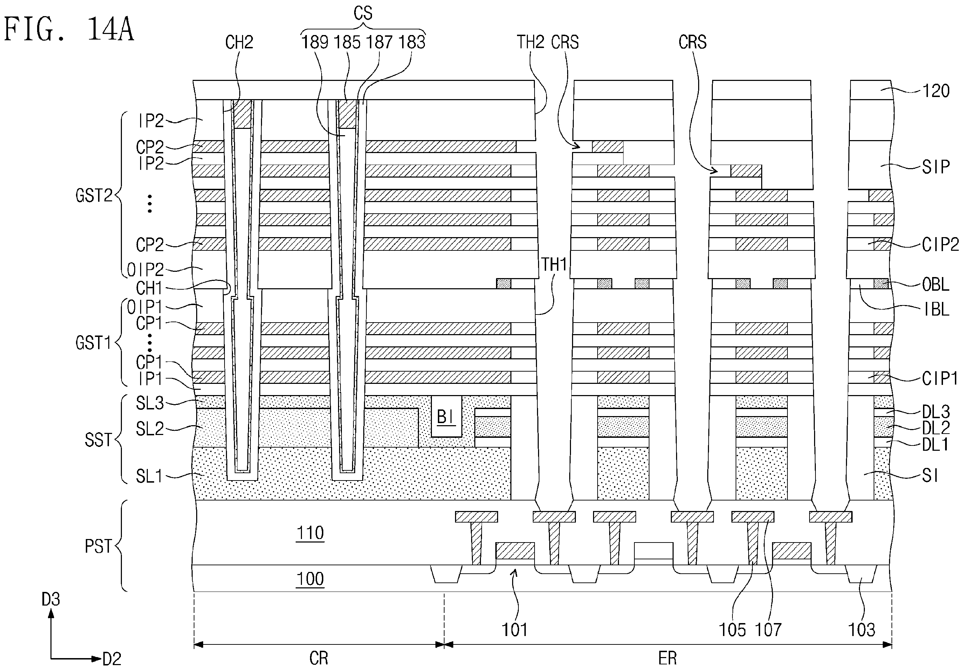

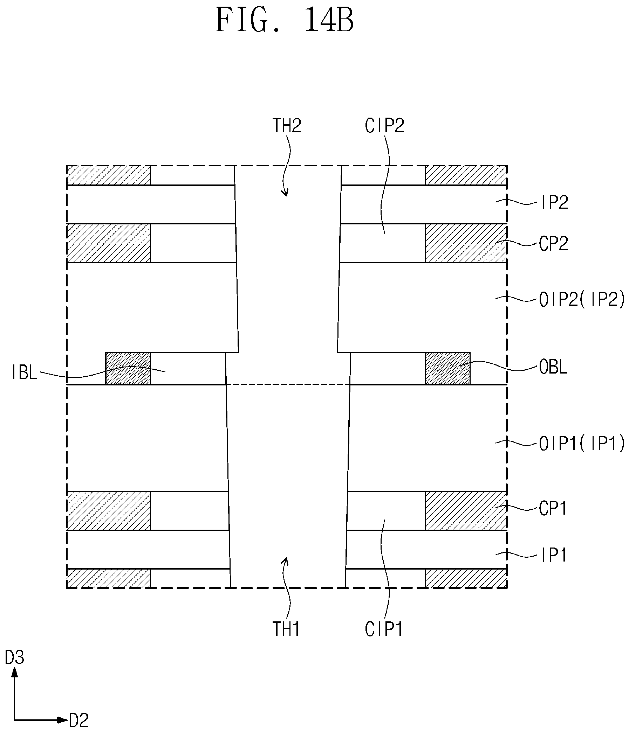

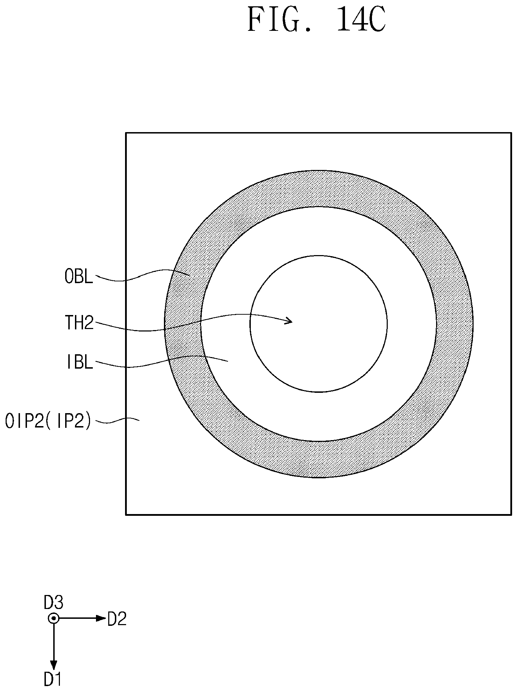

Referring to FIGS. 14A, 14B, and 14C, the first contact insulating patterns CIP1, the second contact insulating patterns CIP2, and the inner barrier layer IBL may be formed. The first contact insulating pattern CIP1 may be formed by filling the recess RS defined by the first sacrificial layer FL1. The second contact insulating pattern CIP2 may be formed by filling the recess RS defined by the second sacrificial layer FL2. The inner barrier layer IBL may be formed by filling the recess RS defined by the outer barrier layer OBL.

The first sacrificial layers FL1 may be replaced with the first conductive patterns CP1, and the second sacrificial layers FL2 may be replaced with the second conductive patterns CP2. The first to third dummy layers DL1, DL2, and DL3 of the source structure SST on the cell region CR may be replaced with the second source layer SL2. The first stack STA1 with the first conductive patterns CP1 may be referred to as the first gate stack GST1. The second stack STA2 with the second conductive patterns CP2 may be referred to as the second gate stack GST2.

In an embodiment, an insulating layer may be formed to fill the recesses RS, and the first and second sacrificial layers FL1 and FL2 may be replaced with the first and second conductive patterns CP1 and CP2. After the formation of the first and second conductive patterns CP1 and CP2, the first and second contact insulating patterns CIP1 and CIP2 and the inner barrier layer IBL may be formed by etching the insulating layer. In this case, the first and second contact insulating patterns CIP1 and CIP2 and the inner barrier layer IBL may be portions of the insulating layer, which are separated from each other by the etching of the insulating layer. In an embodiment, the insulating layer may be formed of or include an oxide material.

Connection recesses CRS may be formed. Some of the recesses RS may not be fully filled with the first contact insulating pattern CIP1 or the second contact insulating pattern CIP2, and such a recess RS may be referred to as the connection recess CRS.

Referring to FIGS. 2A, 2B, 2C, and 2D, the penetration contacts TC may be formed in the first and second penetration contact holes TH1 and TH2. The second cover insulating layer 130 may be formed on the first cover insulating layer 120 and the penetration contact TC. The first contacts 171 may be formed to penetrate the first and second cover insulating layers 120 and 130. The second contacts 172 may be formed to penetrate the second cover insulating layer 130. The third cover insulating layer 140 may be formed on the second cover insulating layer 130. The bit lines 173 and the conductive lines 174 may be formed to penetrate the third cover insulating layer 140.

In a method of fabricating a semiconductor device according to an embodiment of the inventive concept, the preliminary barrier pattern pBP may be used to protect a lower portion of the second connection insulating layer OIL2 in the first etching process of selectively etching the first and second insulating layers IL1 and IL2 and the first and second connection insulating layers OIL1 and OIL2. Accordingly, it is possible to prevent the second connection insulating layer OIL2 from being over-etched in the first etching process.

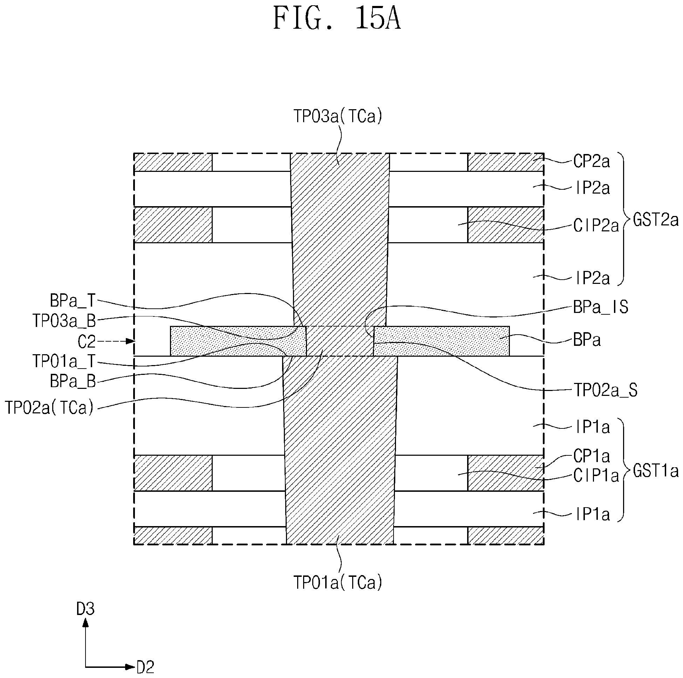

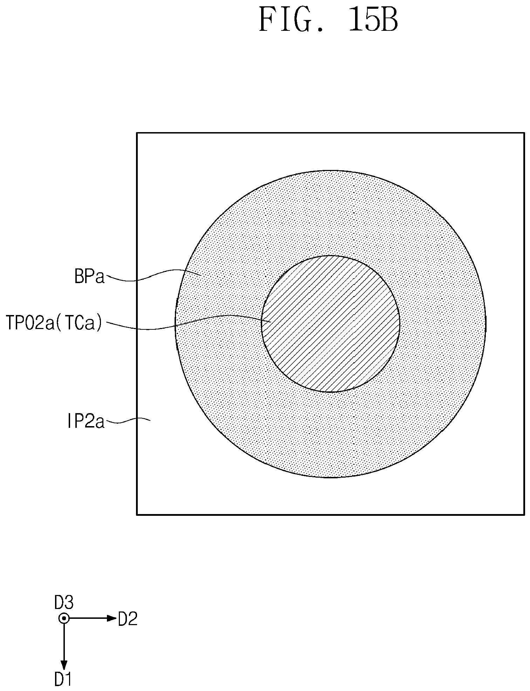

FIG. 15A is an enlarged sectional view illustrating a semiconductor device according to an embodiment of the inventive concept. FIG. 15B is a diagram illustrating a structure of a semiconductor device at a level C2 of FIG. 15A.

Referring to FIGS. 15A and 15B, a semiconductor device may include a first gate stack GST1a, which includes first insulating patterns IP1a, first conductive patterns CP1a, and first contact insulating patterns CIP1a, a second gate stack GST2a, which includes second insulating patterns IP2a, second conductive patterns CP2a, and second contact insulating patterns CIP2a, a barrier pattern BPa, which is provided between the first and second gate stacks GST1a and GST2a, and a penetration contact TCa, which is provided to penetrate the barrier pattern BPa.

In an embodiment, the barrier pattern BPa may be a single layer. The barrier pattern BPa may be formed of or include a material that is different from the first and second insulating patterns IP1a and IP2a and the first and second contact insulating patterns CIP1a and CIP2a. As an example, the barrier pattern BPa may be formed of or include polysilicon.

The penetration contact TCa may include a first penetration portion TPO1a, a second penetration portion TPO2a on the first penetration portion TPO1a, and a third penetration portion TPO3a on the second penetration portion TPO2a.

The first penetration portion TPO1a may be provided to penetrate the first gate stack GST1a. The second penetration portion TPO2a may be disposed at substantially the same level as the barrier pattern BPa. An inner side surface BPa_IS of the barrier pattern BPa may be in contact with a side surface TPO2a_S of the second penetration portion TPO2a. For example, the second penetration portion TPO2a may be disposed between the barrier pattern BPa in the second direction D2. A portion of a top surface BPa_T of the barrier pattern BPa may be in contact with a bottom surface TPO3a_B of the third penetration portion TPO3a. A portion of a bottom surface BPa_B of the barrier pattern BPa may be in contact with a top surface TPO1a_T of the first penetration portion TPO1a.

The largest width of the second penetration portion TPO2a may be smaller than the largest width of the first penetration portion TPO1a and the smallest width of the third penetration portion TPO3a. As an example, the largest width of the second penetration portion TPO2a in the second direction D2 may be smaller than the largest width of the first penetration portion TPO1a in the second direction D2 and the smallest width of the third penetration portion TPO3a in the second direction D2.

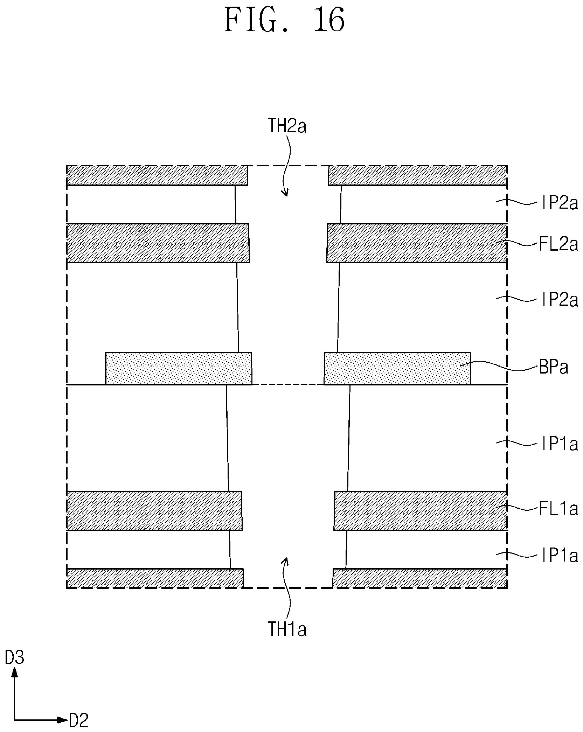

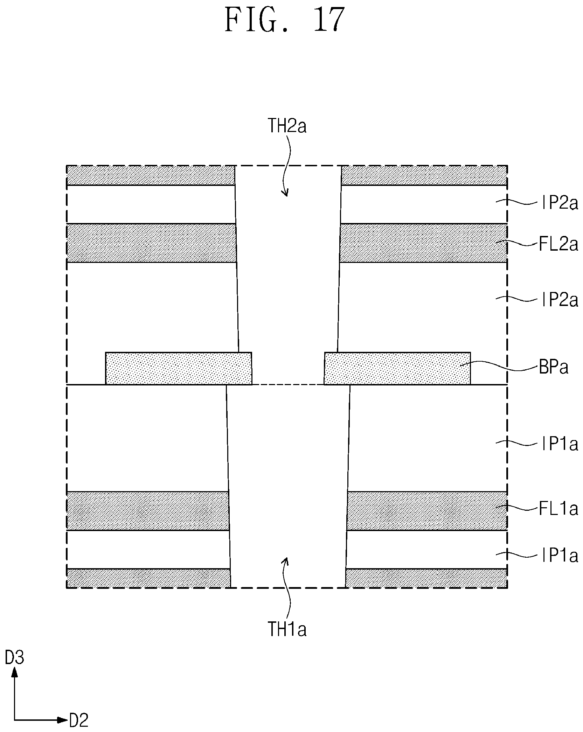

FIGS. 16 and 17 are diagrams illustrating a method of fabricating a semiconductor device, according to an embodiment of the inventive concept.

Referring to FIG. 16, the first insulating patterns IP1a, first sacrificial layers FL1a, the second insulating patterns IP2a, and second sacrificial layers FL2a may be formed, similar to the embodiments of FIG. 3 to 11B. A first penetration contact hole TH1a may be formed to penetrate the first insulating patterns IP1a and the first sacrificial layers FL1a. A second penetration contact hole TH2a may be formed to penetrate the second insulating patterns IP2a, the second sacrificial layers FL2a, and the barrier pattern BPa. The formation of the barrier pattern BPa may include forming a preliminary barrier pattern and forming the second penetration contact hole TH2a to penetrate the preliminary barrier pattern and to define the barrier pattern BPa.

Referring to FIG. 17, the first and second sacrificial layers FL1a and FL2a may be selectively etched. The barrier pattern BPa may not be etched in the process of selectively etching the first and second sacrificial layers FL1a and FL2a. In this case, the barrier pattern BPa may protrude into the second penetration contact hole TH2a. As a result of the selective etching of the first and second sacrificial layers FL1a and FL2a, the first and second penetration contact holes TH1a and TH2a may be enlarged.

Referring to FIGS. 15A and 15B, recesses may be formed by etching the first and second sacrificial layers FL1a and FL2a. The first and second contact insulating patterns CIP1a and CIP2a may be formed in the recesses. The first and second sacrificial layers FL1a and FL2a may be replaced with the first and second conductive patterns CP1a and CP2a. The penetration contacts TCa may be formed in the first and second penetration contact holes TH1a and TH2a, respectively.

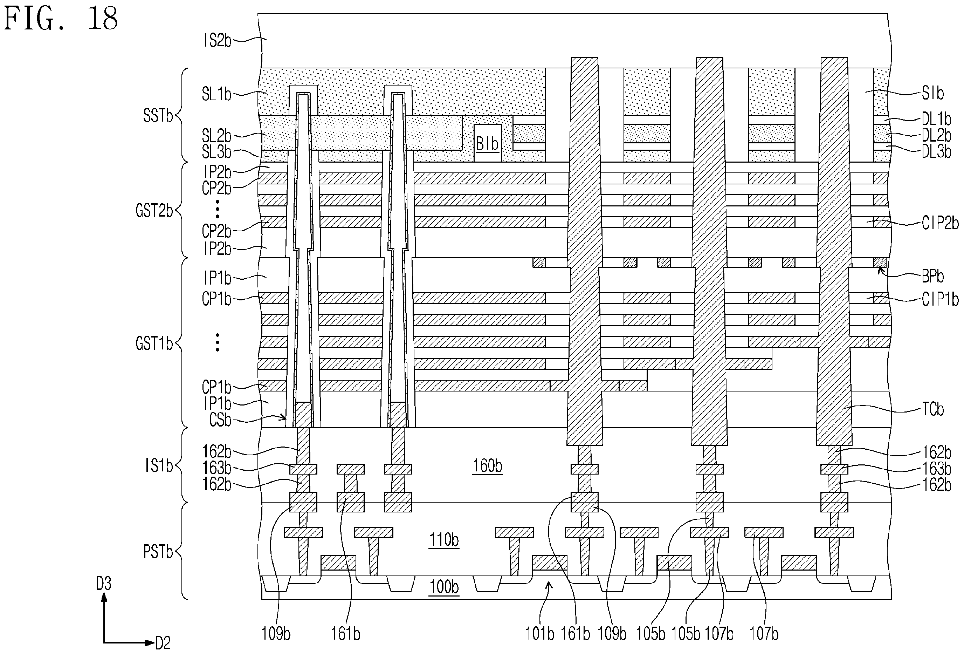

FIG. 18 is a sectional view illustrating a semiconductor device according to an embodiment of the inventive concept.

Referring to FIG. 18, a semiconductor device may include a peripheral circuit structure PSTb, a first insulating structure IS1b on the peripheral circuit structure PSTb, a first gate stack GST1b on the first insulating structure IS1b, a second gate stack GST2b on the first gate stack GST1b, a source structure SSTb on the second gate stack GST2b, and a second insulating structure IS2b on the source structure SSTb.

The peripheral circuit structure PSTb may include a substrate 100b, a peripheral circuit insulating layer 110b, a peripheral transistor 101b, a peripheral contact 105b, and a peripheral conductive line 107b. The peripheral circuit structure PSTb may further include a first bonding pad 109b. The first bonding pad 109b may be electrically connected to the peripheral transistor 101b. The first bonding pad 109b may be formed of or include at least one of conductive materials. In an embodiment, the first bonding pad 109b may be formed of or include copper.

The first insulating structure IS1b may include a connection insulating layer 160b and a second bonding pad 161b, a connection contact 162b, and a connection conductive line 163b, which are provided in the connection insulating layer 160b. The second bonding pad 161b may be bonded to the first bonding pad 109b. The second bonding pad 161b, the connection contact 162b and the connection conductive line 163b may be formed of or include at least one of conductive materials. The second bonding pad 161b may be formed of or include, for example, copper. The connection insulating layer 160b may be formed of or include at least one of insulating materials. In an embodiment, the connection insulating layer 160b may include a plurality of insulating layers.

The first gate stack GST1b may include first insulating patterns IP1b and first conductive patterns CP1b, which are alternately stacked on top of each other. The second gate stack GST2b may include second insulating patterns IP2b and second conductive patterns CP2b, which are alternately stacked on top of each other.

A memory channel structure CSb may be provided to penetrate the first and second gate stacks GST1b and GST2b. The memory channel structure CSb may be electrically connected to the peripheral transistor 101b through the connection contact 162b, the connection conductive line 163b, the second bonding pad 161b, the first bonding pad 109b, the peripheral contact 105b, and the peripheral conductive line 107b.

A penetration contact TCb may be provided to penetrate the first and second gate stacks GST1b and GST2b. The penetration contact TCb may be electrically connected to the peripheral transistor 101b through the connection contact 162b, the connection conductive line 163b, the second bonding pad 161b, the first bonding pad 109b, the peripheral contact 105b, and the peripheral conductive line 107b.

The source structure SSTb may include a first source layer SL1b, a second source layer SL2b, a third source layer SL3b, a first dummy layer DL1b, a second dummy layer DL2b, a third dummy layer DL3b, a source insulating layer SIb, and an insulating gapfill layer BIb.

The first gate stack GST1b may further include a first contact insulating pattern CIP1b enclosing the penetration contact TCb. The second gate stack GST2b may further include a second contact insulating pattern CIP2b enclosing the penetration contact TCb. A barrier pattern BPb may be provided between the first and second gate stacks GST1b and GST2b. For example, the barrier pattern BPb may be provided in the first gate stack GST1b.

The second insulating structure IS2b may be provided on the source structure SSTb. In an embodiment, the second insulating structure IS2b may include a plurality of insulating layers. In an embodiment, the second insulating structure IS2b may include contacts and conductive lines.

In a semiconductor device according to an embodiment of the inventive concept and an electronic system including the same, a barrier pattern may be provided, and this makes it possible to reduce a thickness of a connection insulating pattern and to increase a distance between a penetration contact and a conductive pattern.

While example embodiments of the inventive concept have been particularly shown and described, it will be understood by one of ordinary skill in the art that variations in form and detail may be made thereto.

According to an embodiment of the inventive concept, a semiconductor device includes: a first gate stack including first insulating patterns and first conductive patterns, which are alternately stacked with each other; a second gate stack provided on the first gate stack, the second gate stack including second insulating patterns and second conductive patterns, which are alternately stacked with each other; a memory channel structure penetrating the first gate stack and the second gate stack; a penetration contact penetrating the first gate stack and the second gate stack; and a barrier pattern provides on first and second sides of the penetration contact, wherein the first insulating patterns include a first connection insulating pattern, which is the uppermost one of the first insulating patterns, the second insulating patterns include a second connection insulating pattern which is in contact with a top surface of the first connection insulating pattern, a bottom surface of the barrier pattern is in contact with the top surface of the first connection insulating pattern, and a top surface of the barrier pattern is in contact with the second connection insulating pattern.

According to an embodiment of the inventive concept, a semiconductor device includes: a first gate stack including a first insulating pattern and a first conductive pattern, which are alternately stacked with each other; a second gate stack provided on the first gate stack, the second gate stack including a second insulating pattern and a second conductive pattern, which are alternately stacked with each other; a memory channel structure penetrating the first gate stack and the second gate stack; a penetration contact penetrating the first gate stack and the second gate stack; and a barrier pattern provided on first and second sides of the penetration contact, wherein the first gate stack further includes a first contact insulating pattern provided on the first and second sides of the penetration contact, the second gate stack further includes a second contact insulating pattern provided on the first and second sides of the penetration contact, and the barrier pattern is disposed between the first contact insulating pattern and the second contact insulating pattern.

According to an embodiment of the inventive concept, an electronic system includes: a substrate; a semiconductor device on the substrate; and a controller, which is provided on the substrate and is electrically connected to the semiconductor device, wherein the semiconductor device includes: a first gate stack including first insulating patterns and first conductive patterns, which are alternately stacked with each other; a second gate stack provided on the first gate stack, the second gate stack including second insulating patterns and second conductive patterns, which are alternately stacked with each other; a memory channel structure penetrating the first gate stack and the second gate stack; a penetration contact penetrating the first gate stack and the second gate stack; and a barrier pattern surrounding the penetration contact, wherein the first gate stack further includes first contact insulating patterns disposed on first and second sides of the penetration contact, the second gate stack further includes second contact insulating patterns disposed on the first and second sides of the penetration contact, the first insulating patterns include a first connection insulating pattern, which is disposed at a level higher than the first conductive patterns and the first contact insulating patterns, the second insulating patterns include a second connection insulating pattern, which is disposed at a level lower than the second conductive patterns and the second contact insulating patterns, the barrier pattern is disposed on a top surface of the first connection insulating pattern, and the second connection insulating pattern is in contact with a top surface of the barrier pattern.

## Claims

1. A semiconductor device, comprising:
a first gate stack including first insulating patterns and first conductive patterns, which are alternately stacked with each other;
a second gate stack provided on the first gate stack, the second gate stack including second insulating patterns and second conductive patterns, which are alternately stacked with each other;
a memory channel structure penetrating the first gate stack and the second gate stack;
a penetration contact penetrating the first gate stack and the second gate stack; and
a barrier pattern surrounding a part of the penetration contact,
wherein the first insulating patterns comprise a first connection insulating pattern, which is the uppermost one of the first insulating patterns,
the second insulating patterns comprise a second connection insulating pattern which is in contact with a top surface of the first connection insulating pattern,
a bottom surface of the barrier pattern is in contact with the top surface of the first connection insulating pattern, and
a top surface of the barrier pattern is in contact with the second connection insulating pattern.

2. The semiconductor device of claim 1, wherein the barrier pattern comprises an inner barrier layer encircling the penetration contact and an outer barrier layer encircling the inner barrier layer.

3. The semiconductor device of claim 2, wherein the outer barrier layer comprises a material different from the first connection insulating pattern and the second connection insulating pattern.

4. The semiconductor device of claim 3, wherein the inner barrier layer comprises the same material as the first connection insulating pattern and the second connection insulating pattern.

5. The semiconductor device of claim 4, wherein the inner barrier layer comprises an oxide material, and
the outer barrier layer comprises a nitride material.

6. The semiconductor device of any one of the preceding claims, wherein the barrier pattern has a circular shape.

7. The semiconductor device of any one of the preceding claims, wherein a side surface of the barrier pattern is in contact with the second connection insulating pattern.

8. The semiconductor device of any one of the preceding claims, wherein the penetration contact comprises a first penetration portion penetrating the first gate stack, a second penetration portion on the first penetration portion, and a third penetration portion on the second penetration portion,
the barrier pattern surrounds the second penetration portion, and
the largest width of the second penetration portion is smaller than the largest width of the first penetration portion and the smallest width of the third penetration portion.

9. The semiconductor device of claim 8, wherein the barrier pattern comprises polysilicon.

10. A method of fabricating a semiconductor device, comprising:
forming a first stack including first insulating layers and first sacrificial layers, which are alternately stacked with each other;
forming a first penetration contact hole to penetrate the first stack;
forming a penetration contact sacrificial layer in the first penetration contact hole;
forming a preliminary barrier pattern on the penetration contact sacrificial layer;
forming a second stack, which includes second insulating layers and second sacrificial layers, on the first stack;
forming a second penetration contact hole to penetrate the second stack and the preliminary barrier pattern;
removing the penetration contact sacrificial layer through the second penetration contact hole; and
forming a penetration contact in the first penetration contact hole and the second penetration contact hole.

11. The method of claim 10, further comprising:
etching the first and second insulating layers through a first etching process; and
etching the first and second sacrificial layers and the preliminary barrier pattern through a second etching process.

12. The method of claim 11, further comprising forming recesses through a third etching process of etching the first and second sacrificial layers and the preliminary barrier pattern,
wherein the preliminary barrier pattern, which is etched through the third etching process, is an outer barrier layer.

13. The method of claim 12, further comprising forming contact insulating patterns and an inner barrier layer in the recesses.

14. The method of claim 13, wherein the penetration contact is surrounded by the outer barrier layer and the inner barrier layer.

15. The method of any one of claims 10 to 14, wherein the forming of the preliminary barrier pattern comprises:
forming a preliminary barrier layer on the first stack; and
patterning the preliminary barrier layer.
